# EUROPEAN PATENT SPECIFICATION

(11) **EP 0 492 492 B1**
(45) Date of publication and mention of the grant of the patent: **08.05.1996**
(21) Application number: 91121924.4
(22) Date of filing: 20.12.1991
(51) Int. Cl.: H01R 43/02

(54) **Method of securing a connector to a circuit element and soldering lead frame for use therein**
Verfahren für die Befestigung eines Verbinders an einem Stromkreiselement sowie Lötanschlussrahmen dazu
Procédé de fixation d'un connecteur à un component de circuit et chassis de connexion de soudage associé

(30) Priority: 21.12.1990 US 631814; 21.12.1990 US 631819
(43) Date of publication of application: 01.07.1992
(73) Proprietor: THE WHITAKER CORPORATION, Wilmington, Delaware 19808 (US)
(72) Inventor: Henschen, Homer, Ernst, Carlisle, Pennsylvania 17013 (US); McKee, Michael, John, New Cumberland, Pennsylvania 17070 (US); Pawlikowski, Joseph, Michael, Lancaster, Pennsylvania 17601 (US); Schaeffer, Richard, Lloyd, Carlisle, Pennsylvania 17013 (US); Scholz, James, Paul, Mechanicsburg, Pennsylvania 17055 (US); Shaffer, David, Todd, Mechanicsburg, Pennsylvania 17055 (US); Sharpe, Alexander, Michael, Harrisburg, Pennsylvania 17111 (US)
(74) Representative: Klunker . Schmitt-Nilson . Hirsch

(56) References cited:
- EP-A- 0 158 434
- EP-A- 0 206 620
- EP-A- 0 241 597
- EP-A- 0 250 094
- EP-A- 0 294 966
- EP-A- 0 371 644
- EP-A- 0 371 645
- EP-A- 0 371 646

## Description

The present invention relates to the field of electrical connectors, and more particularly to connectors for electrical connection to circuit elements such as printed circuit boards and the like. Still more particular, the present invention relates to a method of securing an electrical connector to a circuit element, to a lead frame for use in faciliating the soldering of an array of free ends of contact arms of an electrical connector to a corresponding array of conductive means of a circuit element, and to a soldering component for use in faciliating the soldering of an array of free ends of contact arms of an electrical connector to a corresponding array of conductive means.

Electrical connectors are known which include a plurality of electrical contacts having exposed contact sections for electrical connection to circuits of a circuit element, such as conductive traces disposed on a major surface of a printed circuit board. Documents U. S. A-4,903,402 and US-A-4,925,400 disclose similar such connectors which include two arrays of contacts each associated with respective arrays of conductive traces of circuit cards secured to opposed sides of a common central cooling plate of a module such as a line replaceable module (LRM), the connector being secured by fasteners to the cooling plate at an end thereof; the plate, the circuit cards and board-mounted components thereon, and the connector are disposed within protective covers of the module, with the connector having a mating face exposed at the end of the module for mating to another connector.

Arrays of such modules are commonly used in electronics units such as black boxes aboard aircraft, each matable with connectors on a mother board within the unit or box. The contacts are conventionally connected to the conductive traces of the circuit cards by their contact sections being soldered thereto in a surface mount arrangement; the contact sections are defined proximate free ends of elongate cantilever arms. The connector is mounted within the module in such a manner as to be incrementally movable transversely with respect to the module covers and the circuit cards affixed to the cooling plate, upon mating when the module is inserted into the electronics unit or black box; the elongate cantilever arms are flexible, and the incremental movement does not disturb nor overstress the soldered connections of the contacts to the conductive traces of the circuit cards.

Document US-A-4,903,402 also discloses a method of assembling the connector to the circuit cards previously affixed to the cooling plate, and a method of fabricating the connector to facilitate such assembly. The plurality of contacts of a row are stamped and formed while on a continuous carrier strip, as is conventional and the contact sections are precisely spaced apart a selected distance. The carrier strip is joined to the contacts of a row at the free ends of the elongate cantilever arms beyond the contact sections, which are formed into convex shapes enhancing fillet formation of the solder joints. Several rows of contacts associated with a single printed circuit element are to have their contact sections in a common plane to be joined to respective traces on a common surface of the circuit card; the carrier strips of the several rows are joined integrally together after the spaced contact sections of each row are registered with respect to those of the other rows to attain the desired spacing matching that of the trace array to which they will be soldered; the multirow array of contacts of the connector are handled as a unit during connector fabrication. The joined carrier strips are maintained on the arm free ends until after soldering is complete, whereafter the joined strips are carefully broken away in a manner not disturbing the solder joints. The method disclosed maintains the contacts precisely spaced apart to match the close spacing of the traces (such as 0.025 inches (approx. 0,6mm) between trace centerlines), and minimizes tendencies of the elongate cantilever arms to be bent or broken or their spacing disturbed during handling prior to soldering, and thus eliminates the need for alignment tooling at the soldering operation of the type necessary to realign and again precisely space the contact sections of the individual arms to match the respective closely spaced traces.

In Document US-A-4,852,252 electrical contact terminals are disclosed to be soldered to discrete wires after the terminals have been disposed within a dielectric housing, and the terminations sealed from the environment. The solder tail contact section of each terminal extends rearwardly from the housing rearward face; a length of heat recoverable dielectric tubing containing an annular preform of solder centrally along its length placed over the solder tail; the stripped end of the conductor wire is superposed over the solder tail within the tubing, and the solder preform is positioned around the superposed solder tail/wire end. The solder is then melted and flows around the solder tail and wire end, forming a solder joint electrically joining the wire and the terminal; the heat recoverable tubing shrinks in diameter until adjacent the portion of the conductor wire and the terminal within the tubing, and sealant material at ends of the tubing melts and seals the ends of the tubing to the wire insulation and dielectric material of housing flanges extending along a portion of each terminal exiting the housing sealing the termination and exposed metal from the environment.

Document US-A-4,852,252 further discloses providing the terminals each with a thin layer of magnetic material along the surface of the nonmagnetic low resistance solder tail of the terminal facing away from the surface to which the wire end will be soldered; in Document US-A-4,995,838 a preform of foil having a magnetic layer is disclosed to be soldered to the terminal solder tail's wire-remote surface. The bimetallic structure uses the Curie temperature of the magnetic material to define an article which will generate thermal energy when subjected to radiofrequency current of certain frequency for sufficient short length of time until a certain known temperature is achieved, above which the structure is inherently incapable of rising; by selecting the magnetic material and sufficient thickness thereof and selecting an appropriate solder, the temperature achieved can be selected to be higher than the reflow temperature of the solder preform; when the terminal is subjected through induction to RF current of the appropriate frequency, the solder tail will generate heat which will radiate to the solder preform, reflow the solder, and be conducted along the wire and the terminal and radiate further to shrink the tubing and melt the sealant material. The terminal thus includes an integral mechanism for enabling simultaneous soldering and sealing without other application of heat; excess heat is avoided as is the potential of heat damage to remaining portions of the connector or tubing.

Another Document US-A-4,789,767 discloses a multipin connector whose contacts have magnetic material layers on portions thereof spaced from the contact sections to be surface mounted to respective traces on the surface of a printed circuit board. An apparatus is disclosed having a coil wound magnetic core having multiple shaped pole pieces in spaced pairs with an air gap therebetween within which the connector is placed during soldering. The pole pieces concentrate flux in the magnetic contact coating upon being placed beside the contact sections to be soldered, to transmit RF current to each of the contacts, generating thermal energy to a known maximum temperature to reflow the solder and join the contact sections to the conductive traces of the printed circuit element.

Such Curie point heating is disclosed in Documents US-A-4,256,945; US-A-4,623,401; US-A-4,659,912; US-A-4,695,713; US-A-4,701,587; US-A-4,717,814; US-A-4,745,264 and EP-A-0,241,597. When a radio frequency current for example is passed through such a bipartite structure, the current initially is concentrated in the thin high resistance magnetic material layer which causes heating; when the temperature in the magnetic material layer reaches its Curie temperature, it is known that the magnetic permeability of the layer decreases dramatically; the current density profile then expands into the non-magnetic substrate of low resistivity. The thermal energy is then transmitted by conduction to adjacent structure such as wires and solder which act as thermal sinks; since the temperature at thermal sink locations does not rise to the magnetic material's Curie temperature as quickly as at non-sink locations, the current remains concentrated in those portions of the magnetic material layer adjacent the thermal sink locations and is distributed in the low resistance substrate at non-sink locations. It is known that for a given frequency the self-regulating temperature source thus defined achieves and maintains a certain maximum temperature dependent on the particular magnetic material. One source for generating radiofrequency current such as of 13.56 MHz is disclosed in Document US-A-4,626,767.

The conductive substrate can be copper having a magnetic permeability of about one and a resistivity of about 1.72 micro-ohm-centimeters. The magnetic material may be for example a clad coating of nickel-iron alloy such as Alloy No. 42 (42% nickel, 58% iron) or Alloy No. 42-6 (42% nickel, 52% iron and 6% chromium). Typical magnetic permeabilities for the magnetic layer range from fifty to about one thousand, and electrical resistivities normally range from twenty to ninety micro-ohm-centimeters as compared to 1.72 for copper; the magnetic material layer can have a Curie temperature selected to be from the range of between about 200°C to about 500°C, for example. The thickness of the magnetic material layer is typically one to three skin depths; the skin depth is proportional to the square root of the resistivity of the magnetic material, and is inversely proportional to the square root of the product of the magnetic permeability of the magnetic material and the frequency of the alternating current passing through the two-layer structure. Solders can be tin-lead such as for example Sn 63 reflowable at a temperature of about 183°C or Sb-5 reflowable at a temperature of about 240°C. Generally it would be desirable t select a Curie temperature of about 50°C to 75°C above the solder reflow temperature.

From document EP-A1-0,371,646, a self-regulating temperature heater with thermally conductive extensions has come to be known. Within this known temperature heater, spaced contact pads on a printed circuit board are soldered to respective spaced contacts in a cable or connector assembly by means of respective spaced connecting member interposed between contacts to be soldered. The connecting members are typically electrically and thermally conductive finger-like projections formed as part of a heater body and are readily separable from the heater body after soldering to thereby remain part of the final solder connection. A prescribed amount of fusible material (e.g. solder) is pre-deposited on the connecting members or contacts and is melted when the heater is actuated. The heater body may be a self-regulating heater in the form of a copper substrate having a thin surface layer of magnetically permeable, high-resistance alloy. And alternating current of constant amplitude and high frequency is passed through the heater body and is concentrated in the surface layer at temperatures below the surface layer Curie temperature. As higher temperatures, the current distributed to the lower resistance substrate to limit full heating. During the time interval required for the surface layer to reach its Curie temperature, the resistive power dissipation creates sufficient thermal energy to melt the pre-deposited solder. The connecting members are positioned and configured as necessary to reach the respective connection sites.

It is desirable to simplify the process of soldering contact sections to circuit traces.

It is also desirable to eliminate the need at soldering to realign the individual ones of the plurality of contact sections at ends of elongate cantilever beam arms, and the combing tooling necessary to such individual arm realignment.

It is especially desirable to perform soldering in a process not subjecting all portions of the printed circuit element and the connector to the high temperatures requisite to reflow solder.

It is further desirable to simplify the providing of solder at discrete solder joint sites for such soldering.

It is an objective of the present invention to fabricate a connector to have an integral means to maintain the precise spacing and alignment of pluralities of contact arms having contact sections defined thereon and especially when the contact arms are elongate cantilever beams, during shipping and handling prior to eventual soldering of the contact sections to conductive traces of circuit elements.

It is another objective to provide for a simplified process of soldering of the contact sections of a connector to conductive traces of circuit elements, and simplify the tooling necessary to prepare the connector for soldering at the soldering site.

It is yet another objective to provide a connector assembly having integral means to generate thermal energy at only the contact sections thereof to a selected known maximum temperature sufficient to reflow solder to define solder joints to conductive traces of circuit elements, thereby protecting all remaining portions of the connector and the circuit element.

It is an additional objective to provide such a connector with discrete solder preforms for its contact sections.

These technical problems are solved according to the invention by a method of securing an electrical connector as set out with independent claim 1, by a lead frame as set out with independent claim 5, and by a soldering component according to the features of independent claim 8.

Dependent claims 2 to 4, 6 and 7 and 9 exhibit not-trivial advantageous improvements of the subject-matter of the claims to which they refer back, respectively. Each of these subject-matters, taken alone, involves an inventive step.

The present invention is related to a method of soldering an array of contact sections of a plurality of contacts of a multicontact connector to a corresponding array of respective traces on the surface of a printed circuit element such as a VHSIC card or the like, without the need of precisely respace or realign each elongate cantilever beam arm of one or more rows of contacts of the connector with the respective traces utilizing expensive comb tooling in a time-consuming process, in order to perform soldering at a site remote from the site of manufacture of the connector. The connector is first fabricated with at least one array of one or more rows of contacts on each side, each array associated with a common trace-containing surface of a printed circuit element such that first contact sections of the terminals of each array are proximate free ends of the cantilever beam arms of the contacts and are disposed in a common plane even if the body sections of the contacts are arranged in a plurality of rows within the housing of the connector so that second contact sections at the other ends are arranged in a multirow array for mating with a mating connector. The first contact sections are disposed side-by-side at equally spaced intervals corresponding to the traces of the printed circuit element to which they are to be soldered.

In a first embodiment, a conductive strip or lead frame is fabricated having a plurality of thin, narrow fingers coextending transversely from an elongate common carrier strip, from a low resistance, low magnetic permeability metal such as beryllium copper. Each finger is spaced to be associated with a respective one of the first contact sections of one of the arrays of contacts of the connector. Along the carrier strip section a second layer is defined superposed on a major surface thereof, the carrier strip comprising the first layer, the second layer being of a metal which has high magnetic permeability and high resistance such as a nickel-iron alloy having a thickness of about 0.0005 inches (approx.0,013mm) or about one-and-one-half to two times the thickness of a "skin depth" of the particular metal. With the first contact sections being for example about 0.010 inches (approx. 0,25mm) wide the fingers would be as wide. The thickness of the fingers preferably is reduced by skiving on both the contact-proximate surface and the opposed trace-proximate surface to define recesses within each of which is deposited a respective inlay or preform of solder.

One of the lead frames thus defined, including the bimetallic carrier strip and the fingers with solder preforms on both sides, is then joined to the free ends of the elongate cantilever beam arms of each contact of each array, with the fingers superposed to coextend along the first contact sections thereof, on the trace-proximate surface, after which flux is preferably added. Through the use of comb tooling (during connector fabrication), the elongate cantilever beam arms are maintained precisely spaced from each other and the first contact sections held coplanar, and the fingers of the lead frame are maintained against the trace-proximate surfaces of the first contact sections; tooling of an apparatus for generating alternating high frequency, constant amplitude current of for example 13.56 MHz is positioned at least proximate, and may be held against, the magnetic layer of the carrier strip section of the lead frame and activated for a small length of time such as for example seven to ten seconds. Thermal energy is generated by the bimetallic carrier strip to a temperature higher than the melting point of the solder preform for a very brief time sufficient to reflow the solder preforms; the solder adjacent the contact section then cools to form a solder joint to the contact section. Preferably the trace-proximate surface of the fingers is supported by tooling having solder resistive surfaces; the solder of the opposed trace-proximate side of each finger simply resolidifies. Conductive strips may joined to both arrays of first contact sections sequentially or simultaneously.

The connector with lead frames joined to all of the arrays of elongate cantilever beam arms thereof then comprises an assembly ready to be soldered to a circuit element, such as VHSIC cards secured to both sides of a central cooling plate, or perhaps to both surfaces of a single two-sided circuit board. The circuit element is inserted between the lead frames of both arrays and between and against the trace-proximate solder preforms of the fingers of both strips and registration attained of the traces with the fingers and indirectly with the first contact sections on contact-proximate surfaces of the fingers. The presoldering steps are performable without the need to reassure alignment and spacing of the individual first contact sections since the bimetallic carrier strips of the lead frames maintain the spacing and alignment during handling and shipping of the connector assembly prior to soldering which may easily now be performed remote from the site of connector manufacture without expensive contact arm realignment and respacing and special alignment tooling therefor.

The contact sections are pressed against the respective traces to assure engagement of the solder preforms of the lead frame fingers with the traces; flux is again added at the solder sites; the bimetallic carrier strip is again engaged by RF-transmitting tooling of an RF generating apparatus; and the lead frames again generate thermal energy sufficient to reflow solder; solder joints are now formed joining the trace-proximate surfaces of the fingers to the conductive traces of the circuit elements, and the solder joints of the fingers to the first contact sections again resolidify so that the first contact sections are now soldered to the traces. The carrier strip extending away from the arm free ends and away from the solder joints is now carefully manipulated to be broken from the fragile fingers extending therefrom and removed from the now-soldered assembly, electrically isolating all the joints of first contact sections and circuit traces and defining discrete electrical connections of the connector contacts with the circuit element traces.

In accordance with a second embodiment, a soldering component is secured to the first contact sections of the array, the component including a block of thermally insulative solder resistive material extending along the array, to which a conductive lead frame is secured along the outer surface of the block. The lead frame is fabricated having a plurality of thin, narrow fingers coextending transversely from an elongate common body section, and the fingers are spaced to be associated with a respective one of the first contact sections of the connector contact array, with the fingers disposed in respective grooves of the block.

The elongate body section and fingers of the lead frame are stamped from a strip of low resistance, low magnetic permeability metal such as beryllium copper; along the body section a second layer is defined superposed on a major surface thereof, the body section comprising the first layer, the second layer being of a metal which has high magnetic permeability and high resistance such as a nickel-iron alloy having a thickness of about 0.0005 inches (approx. 0,013mm) or about one-and-one-half to two times the thickness of a "skin depth" of the particular metal. With the first contact sections being for example about 0.010 inches (approx. 0,25 mm) wide, the fingers would be as wide. The thickness of each finger preferably is reduced by skiving to define a recess within each of which is deposited a respective inlay or preform of solder facing outwardly from the block surface as the finger is disposed along and against the bottom of a respective groove of the block. The body section is secured to the outer surface of the block so that the second layer is preferably facing outwardly.

The soldering component is then joined to the free ends of the elongate cantilever beam arms of each contact of each array, with the fingers superposed to coextend along the first contact sections thereof, on the trace-remote surface, after which flux is preferably added. Through the use of comb tooling (during connector fabrication), the elongate cantilever beam arms are maintained precisely spaced from each other and the first contact sections held coplanar; the soldering block is then carefully urged against the contact arm array so that the contact arm free ends are received into the grooves of the block and the fingers of the lead frame within the grooves are maintained against the trace-remote surfaces of the first contact sections; tooling of an apparatus for generating alternating high frequency, constant amplitude current of for example 13.56 MHz is positioned at least proximate, and may be held against, the magnetic layer of the body section of the lead frame and activated for a small length of time such as for example three to five seconds. Thermal energy is generated by the bimetallic body section to a temperature higher than the melting point of the solder preform for a very brief time sufficient to reflow the solder preforms and join the fingers to the contact section; the solder adjacent the contact section then cools to form a solder joint to the contact section. Soldering components may be joined to both arrays of first contact sections sequentially or simultaneously.

The connector with a soldering component joined to each of the arrays of elongate cantilever beam arms thereof then comprises an assembly ready to be soldered to a circuit element, such as VHSIC cards secured to both sides of a central cooling plate, or perhaps to both surfaces of a single two-sided printed circuit board. The circuit element is inserted between the lead frames of both arrays and against the trace-proximate surfaces of the first contact sections of the connector, and registration attained of the traces with the first contact sections. The presoldering steps are performable without the need to reassure alignment and spacing of the individual first contact sections since the soldering components maintain the spacing and alignment during handling and shipping of the connector assembly prior to soldering which may easily now be performed remote from the site of connector manufacture without expensive contact arm realignment and respacing and special alignment tooling therefor.

The contact sections are pressed against the respective traces to assure engagement therewith during soldering; flux is again added at the solder sites; the bimetallic body section is again engaged by RF-transmitting tooling of an RF generating apparatus; and the lead frames again generate thermal energy sufficient to reflow solder. The solder now flows around the edges of the contact arm free ends and wicks into the regions between the convex arcuate first contact section and the respective trace; solder joints are now formed joining the first contact sections to the conductive traces of the printed circuit elements. The soldering component is now carefully manipulated by limited pivoting about the end of the free ends of the contact arm array, for the fingers extending therefrom to be broken near the contact arm free ends and the solder component and the body section removed from the now-soldered assembly, electrically isolating all the joints of first contact sections and circuit traces and defining discrete electrical connections of the connector contacts with the circuit element traces.

With the present invention, no manual soldering is thus necessary nor another conventional soldering process, such as a vapor phase reflow process, wherein the entire printed circuit element would be have to be subjected to high temperatures of the levels necessary to reflow solder in order to mount the connector contacts to the traces. With heat generated very quickly at only the solder sites for only a very brief time period, little heat remains to have deleterious effects. Delamination of conventional printed circuit boards as is common with hand soldering especially, is thus avoided. The present invention also enables electronic components such as integrated circuit chips and even optical devices such as LEDs and detectors and their associated terminated fiber optic cables to be mounted such as by soldering to the circuit element, prior to mounting the connector to the circuit element, if desired.

Multiple embodiments of the present invention as well as numerous advantages obtained therewith, will now be described by way of example, with reference to the accompanying drawings, in which:
FIGURE 1 illustrates a connector of the type with which the present invention is especially useful, having multirow arrays of contacts extending from a mounting face in opposing pairs to be soldered to a planar circuit element inserted therebetween having conductive traces defined on surfaces thereof;
FIGURE 2 is an enlarged partial section view of a portion of the connector of Figure 1 showing opposed arrays of elongate cantilever beam arms of the contacts extending from multiple rows in the housing to single opposed rows of free ends on inwardly facing surfaces of which are the contact sections in common planes to be soldered to the traces;
FIGURE 3 is a lead frame according to a first embodiment of the present invention with a plurality of fingers coextending from a carrier strip, the carrier strip having a layer of magnetic material thereon and the fingers having solder inlays thereon;
FIGURES 4 to 6 are enlarged cross-section views of the lead frame of Figure 3, after skiving and stamping from a strip of copper alloy stock, after forming of the magnetic material layer and the solder inlays, and after bending respectively, with the thickness dimensionally greatly exaggerated;
FIGURES 7 and 8 are enlarged partial section perspective views of the connector of Figure 1 having the lead frames of Figure 3 soldered thereto, before and after insertion of the planar circuit element inserted between the opposed arrays of contact sections;
FIGURE 9 is a broken elevation view of the connector of Figures 7 and 8;

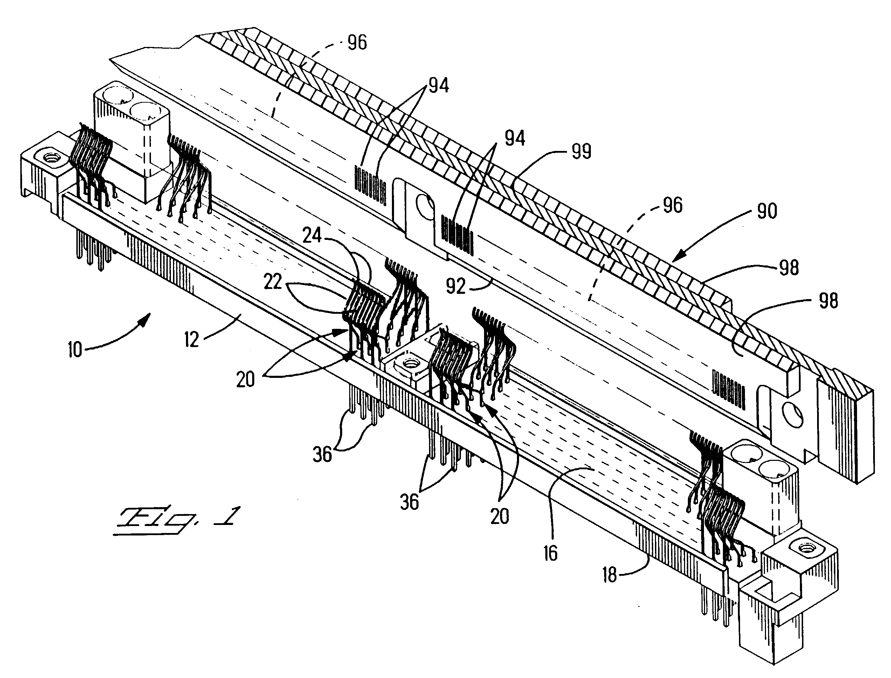

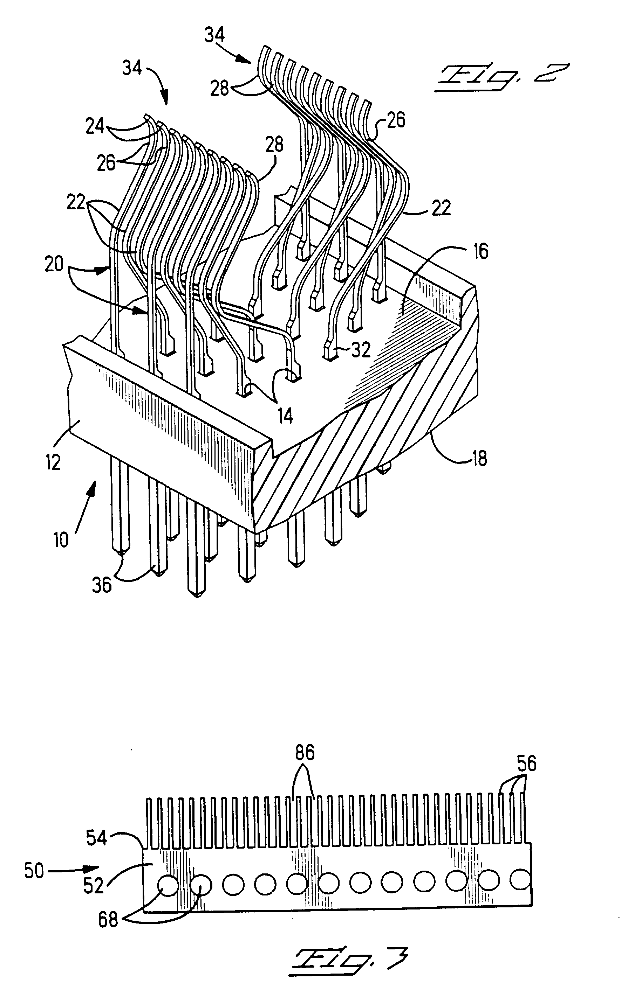

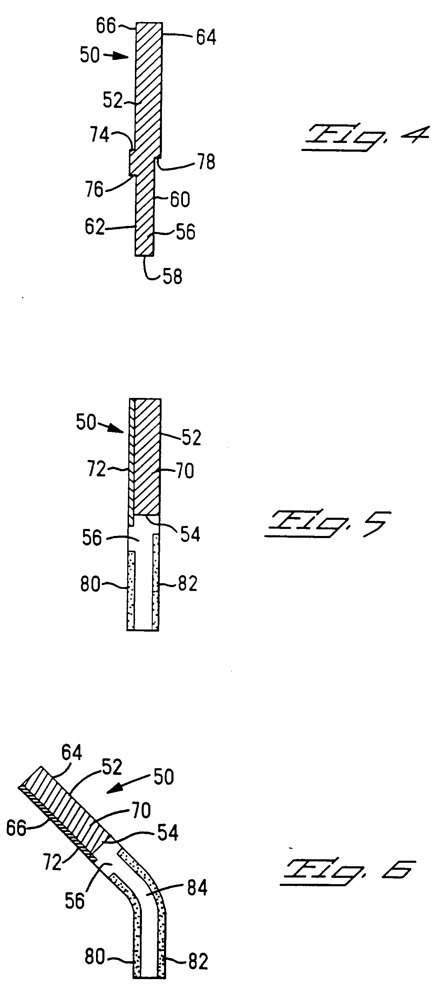

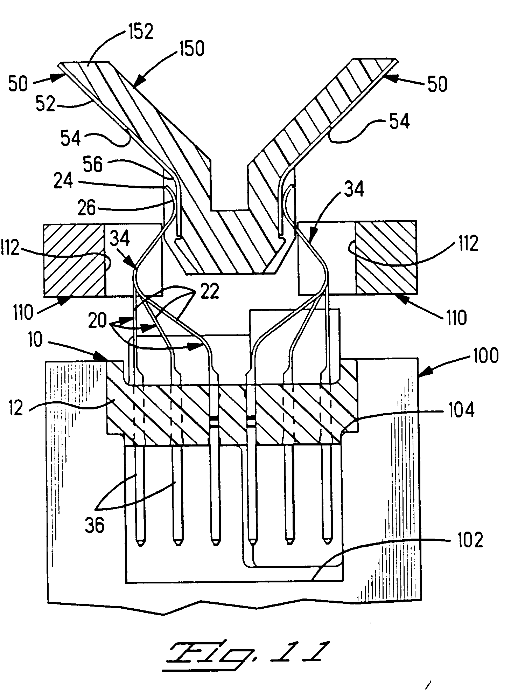

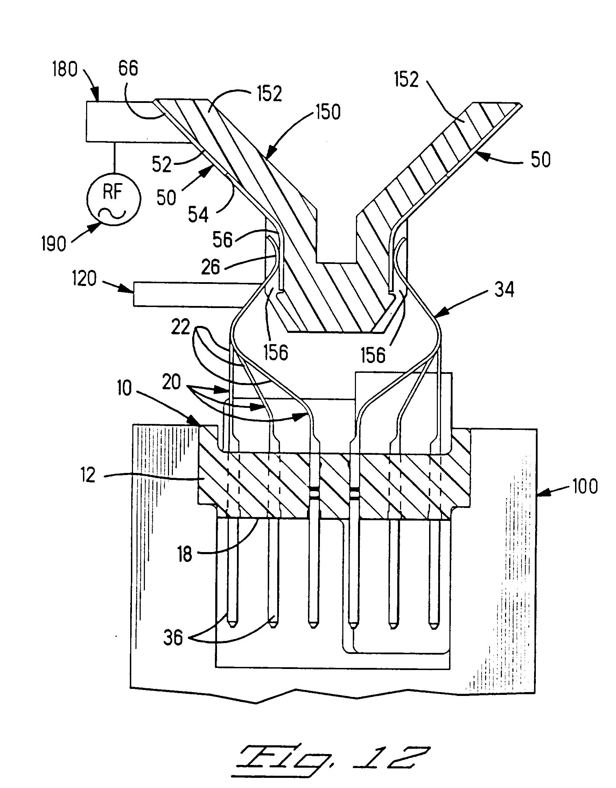

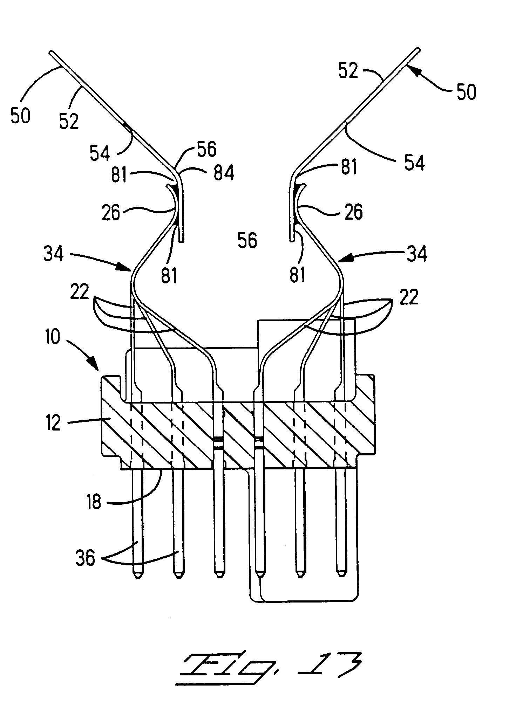

FIGURES 10 to 13 are diagrammatic section views illustrating the method of securing the lead frame of Figure 3 to an array of contact arms of the connector of Figure 1, showing respectively, a lead frame on a support member being inserted between the contact arm arrays of the connector with the arms positioned within alignment comb tooling, the supported lead frame fully inserted in registration with the contact arms, one of the carrier strips engaged by RF-transmitting tooling to heat and reflow the solder inlays of one array, and the connector assembly after lead frames have been soldered to both of the opposing contact section arrays;

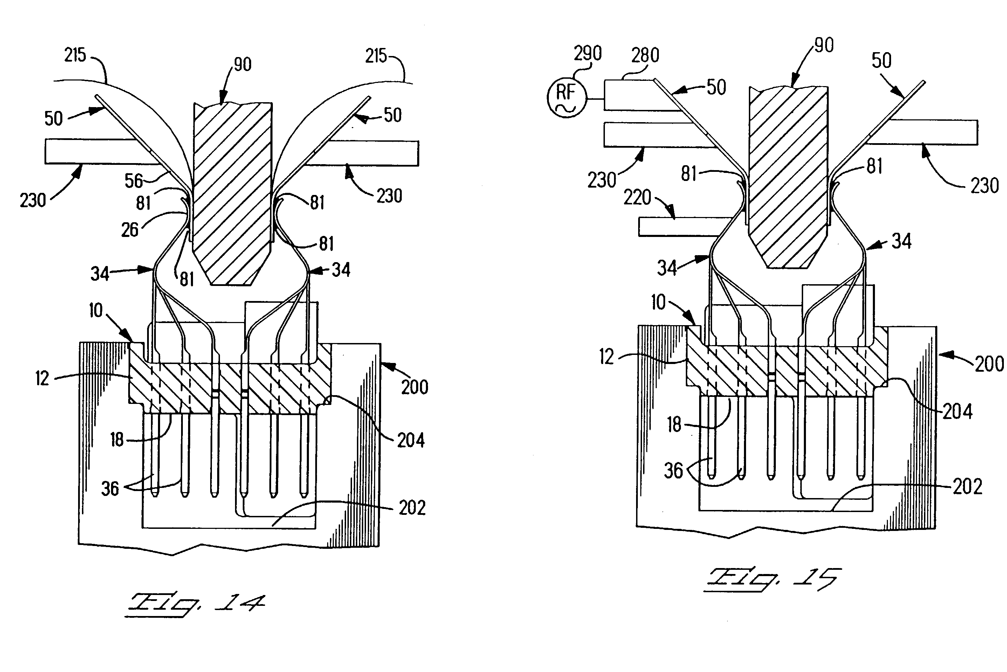

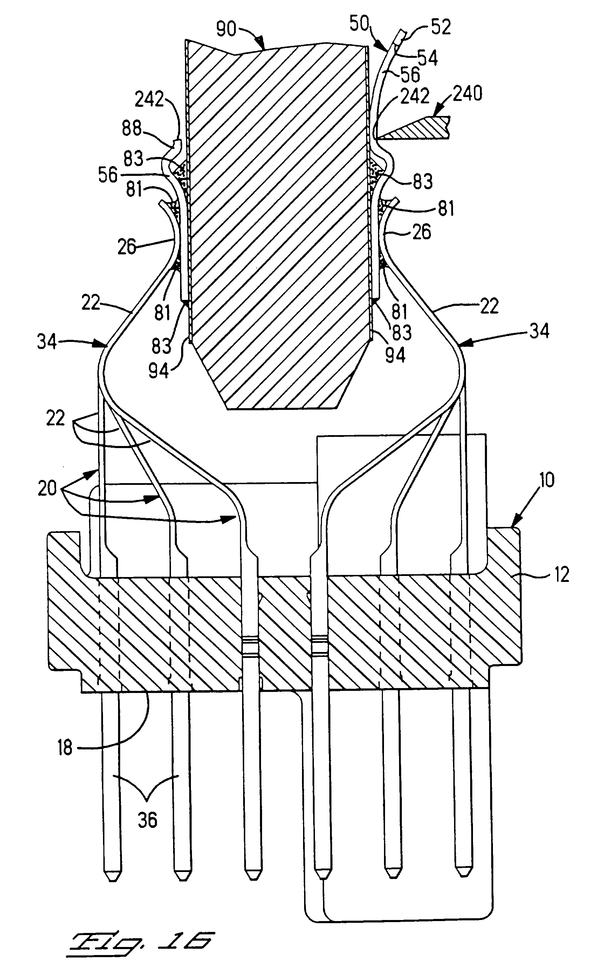

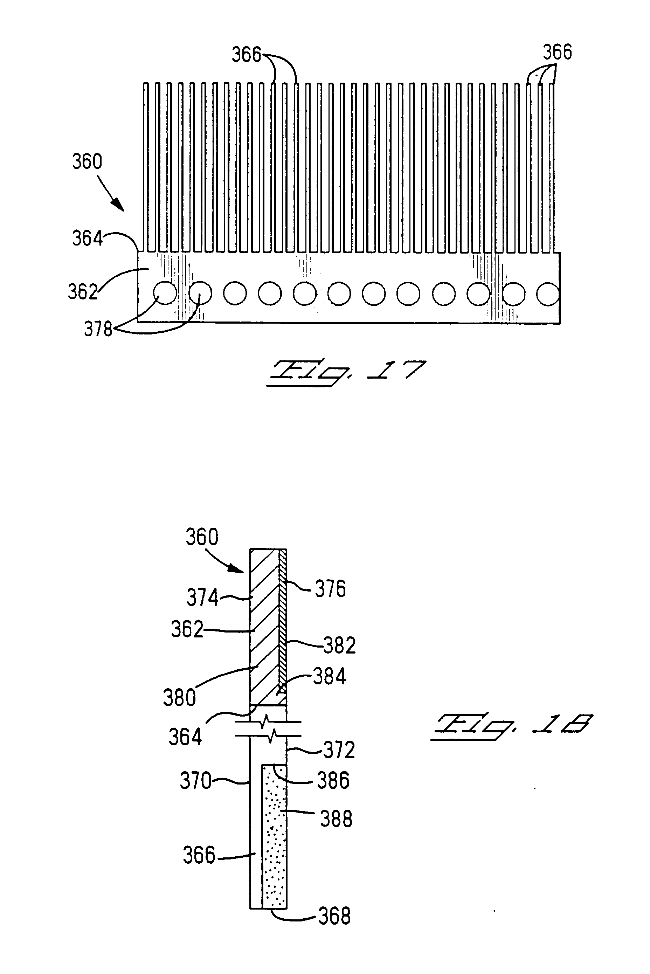

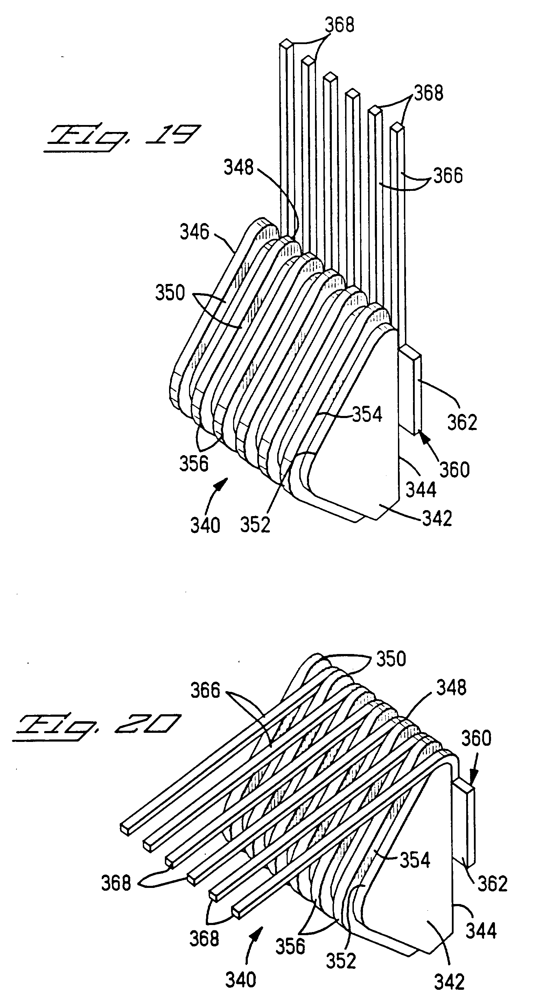

FIGURES 14 to 16 are diagrammatic section views of the connector assembly with lead frames of Figure 13 being soldered to a planar two-sided circuit element, showing respectively, the connector assembly positioned in support tooling with the circuit element inserted between the contact section arrays and the traces thereof registered, the contact sections and fingers supported and the carrier strip for one of the arrays engaged by RF-transmitting tooling to heat and reflow the solder inlays, and the connector assembly soldered to both sides of the circuit element and the carrier strip being broken away from one side thereof;
FIGURES 17 and 18 illustrate a lead frame according to a second embodiment of the present invention with a plurality of fingers coextending from a body section, the body section having a layer of magnetic material thereon and the fingers having solder preforms thereon, after skiving and stamping from a strip of copper alloy stock and forming of the magnetic material layer and the solder inlays;
FIGURES 19 to 22 are enlarged partial section perspective views illustrating forming the lead frame about the block member so that the fingers are formed into the grooves and against the outer surface of the block member;
FIGURES 23 and 24 are enlarged partial section perspective views of the connector of Figure 1 having the soldering components of Figure 22 soldered thereto, before and after insertion of the planar circuit element inserted between the opposed arrays of contact sections;
FIGURE 25 is a diagrammatic section view illustrating the method of securing the solder component of Figure 22 to an array of contact arms of the connector of Figure 1, showing a soldering component positioned against outer surfaces of the contact arm arrays of the connector and in registration therewith, the carrier strip engaged by RF-transmitting tooling to heat and reflow the solder preforms of one array;
FIGURES 26 and 27 are enlarged partial section views of a groove of soldering component showing a lead frame finger with solder thereon and an associated contact section, before and after soldering respectively, to join the component of Figure 22 to the connector of Figure 1; and
FIGURES 28 to 30 are diagrammatic section views of the connector/soldering component assembly of Figure 23 being soldered to a planar two-sided circuit element, showing respectively, the assembly positioned in support tooling with the circuit element inserted between the contact section arrays and the traces thereof registered, the soldering component for one of the arrays engaged by RF-transmitting tooling to heat and reflow the solder preforms, and the assembly soldered to both sides of the circuit element and the soldering component being broken away from one side thereof.

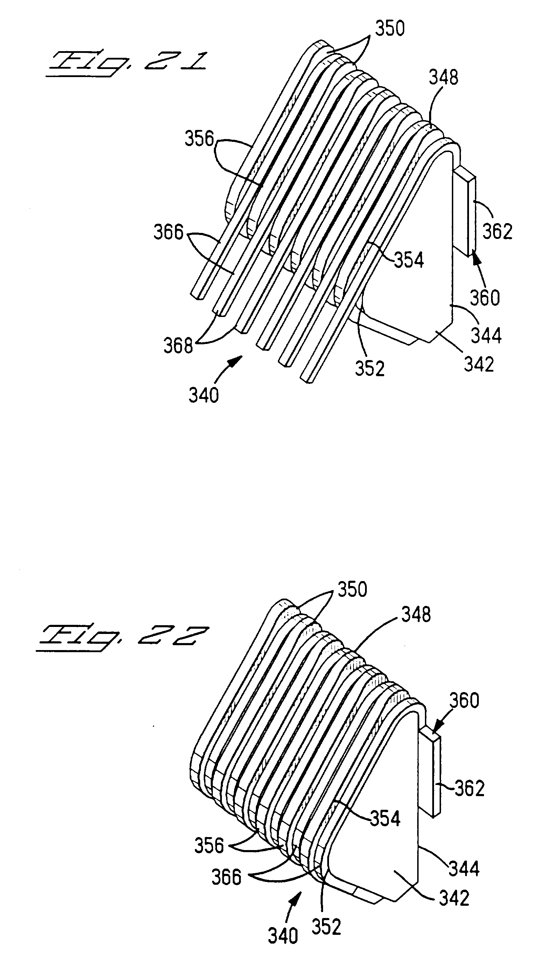

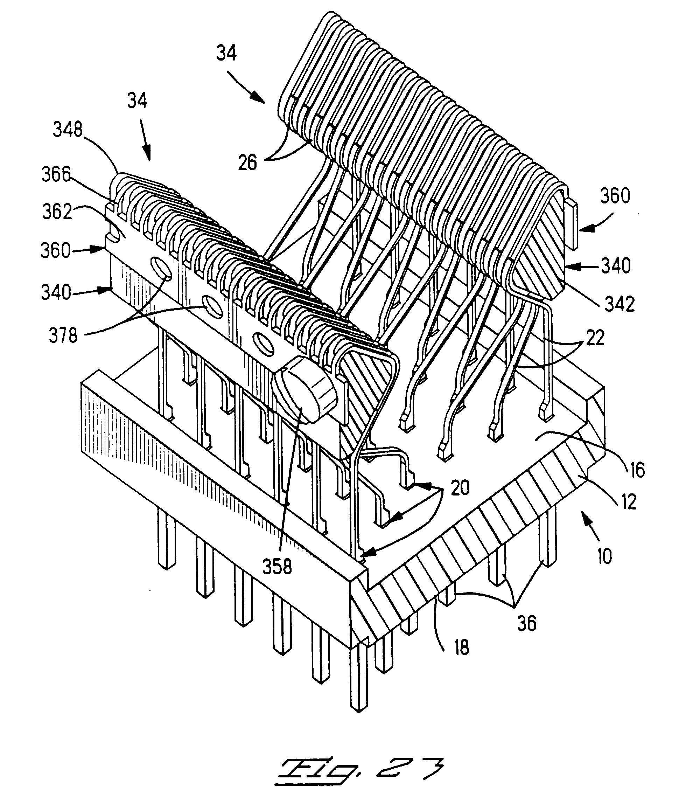

Connector 10 of Figures 1 and 2 is of the type to be mounted to an end 92 of a circuit element 90 to be enclosed within covers (not shown) to define a line replaceable module (LRM) similar to that disclosed in U. S. Patents Nos. 4,903,402 and 4,925,400. Connector 10 includes a housing 12 of dielectric material such as polyphenylene sulfide having passageways 14 therethrough, with respective contacts 20 secured therein. Elongate cantilever beam arms 22 of contacts 20 extend rearwardly from mounting face 16 of housing 12 to free ends 24. First contact sections 26 proximate free ends 24 are arcuately shaped with trace-proximate surfaces 28 adapted to be soldered to corresponding traces 94 of circuit element 90 proximate end 92 thereof. Although not shown herein, the connector also will generally have an alignment means and keying members secured therein along the mating face; and the connector may optionally include passageways for fiber optic terminals to enable transmission of optical signals to and from the circuit element. Circuit element 90 may be a two sided printed circuit board (see Figure 16) or, as shown, comprise a composite structure of a central cooling plate 99 on both sides of which are mounted Very High Speed Integrated Circuit (VHSIC) cards 98 near end 92 on which are defined traces 94 arranged in arrays 96; electrical and electronic components and, optionally, optical devices are then to be mounted on circuit element 90 within the covers of the LRM module which are connected to an electronic apparatus by connector 10 when mated witha mating connector of the apparatus.

Contacts 20 are shown arranged in longitudinal rows 30 along each side of housing 12, with arms 22 extending from body sections 32 disposed within passageways 14; the arms of the contacts in the different rows of each side have slightly differing lengths and are formed into different cursive configurations so that free ends 24 of arms 22 of each side are side-by-side and the trace-proximate surfaces 28 are coplanar, defining opposed arrays 34; free ends 24 extend slightly outwardly from opposed arrays 34. Arrays 34 correspond with arrays 96 of conductive traces 94 of circuit element 90, with contact sections 26 precisely spaced to correspond with individual ones of traces 94. Contacts 20 also include second contact sections 36 extending forwardly of mating face 18 of housing 12 for electrical engagement with corresponding contacts matable therewith of a mating connector (not shown).

Second contact sections 36 and body sections 32 mayhave a square cross-section about 0.017 inches (approx. 0,43 mm) on a side, while arms 22 may have a cross-sectional configuration dimensioned about 0.010 inches (approx. 0.25mm) along the array and a thickness of about 0.007inches (approx. 0.18mm). Elongate cantilever beam arms 22 thus are specifically adapted by shape, dimension and length to be flexible between free ends 24 and body sections 32. When first contact sections 26 are soldered to respective traces 94 of circuit element 90, and connector housing 12 is mounted thereto, connector 10 is incrementally movable with respect to circuit element 90 thus facilitating lateral adjustment of the connector during alignment with a mating connector when the completed module is inserted into the electronic apparatus (such as a black box) along guide channels of the apparatus. Contacts 20 may for example be formed of beryllium copper with nickel underplating and gold plating of second contact sections 36 and tin-lead plating on first contact sections 26.

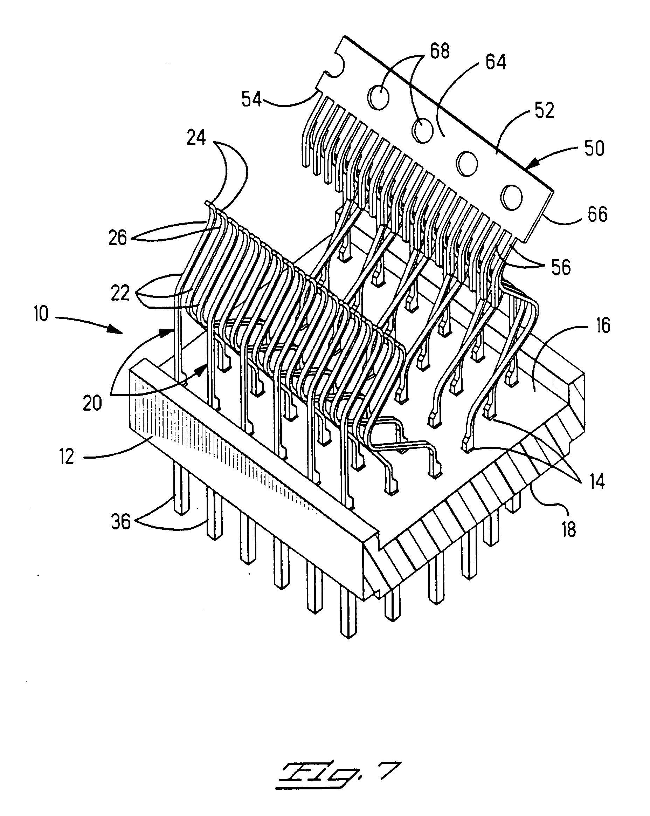

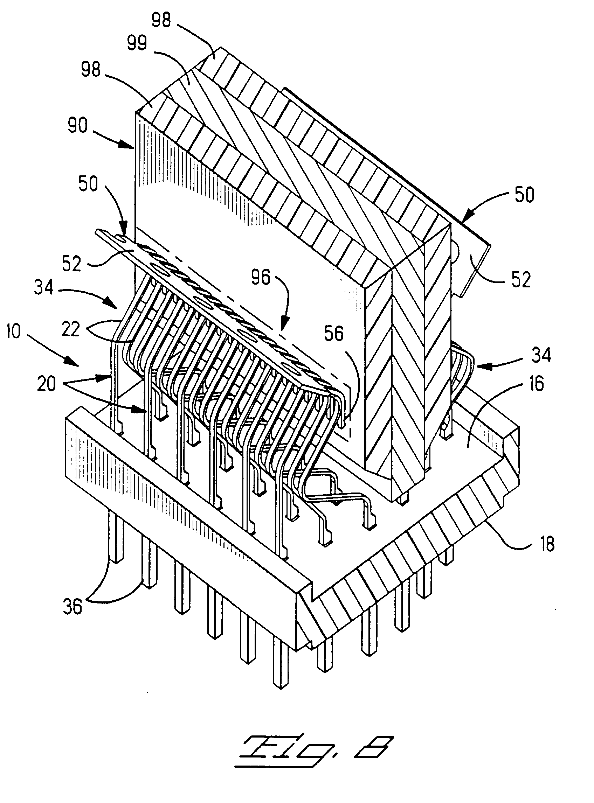

Figures 3 to 6 show a lead frame 50 of the present invention, several of which are to be used with connector 10. Each lead frame 50 includes a carrier strip section 52 outwardly from one lateral edge 54 of which coextend a plurality of fingers 56 to free ends 58. Fingers 56 each are associated with and spaced to correspond with a respective first contact section 26 of an array 34 thereof, and fingers 56 are to be soldered to trace-proximate surfaces 28 of contact sections 26 as will be hereinafter described in detail. After lead frames 50 are secured by soldering to the respective arrays 34, a connector assembly will be defined which will be ready to be soldered to a circuit element 90; fingers 56 will be interposed between trace-proximate surfaces 28 of contact sections 26 and the respective traces 94 after soldering, and can be said to themselves have a trace-proximate side 60 and a contact-proximate side 62 near free ends 58 thereof. Carrier strip section 52 can also be said to have a trace-proximate surface 64 and a trace-remote surface 66, and also includes a plurality of regularly spaced registration holes 68.

In Figures 4, 5 and 6 carrier strip 52 and fingers 56 are initially stamped as an integral member from a thin strip of low resistance metal such as a copper alloy, and the copper alloy of strip 52 will be referred to as first layer 70; a second layer 72 of magnetic material is disposed along trace-remote surface 66 of first layer 70 of carrier strip 52 in intimate bonded relationship with first layer 70 such as is attainable with known methods of cladding a thin layer of metal to a metal surface. Preferably second layer 72 is incrementally thin and is disposed within a skived recess 74 of carrier strip 52. Each finger 56 is shown to have a reduced thickness by being skived on both contact-proximate side 62 to define a first recess 76 and on trace-proximate side 60 to define a second recess 78. All such skiving is preferably performed prior to stamping, and stamping may be performed on a copper alloy strip of double width thus creating a pair of continuous lead frames simultaneously which may be subsequently severed across the joined finger ends. Solder material is deposited in first recess 76 and second recess 78 to form first and second inlays or preforms 80,82 respectively, such as by roll cladding or electrodeposition. After the magnetic material and the solder inlays are defined on the lead frame, the fingers are bent around a radiused bend 84 so that the carrier strip assumes an angle away from the side of its trace-proximate surface 64. Second inlay 82 extends farther along trace-proximate side 60 toward lateral edge 54 than first inlay 80, but preferably both inlays extend around bend 84.

Lead frame 50 may be fabricated from strip stock of a low resistance, low magnetic permeability metal such as brass or Copper Alloy C21000 of beryllium copper and having a thickness of about 0.010 inches (approx. 0,25 mm) before skiving. Second layer 72 is of a metal which has high magnetic permeability and high resistance, the second layer for example being Alloy No. A-42 of nickel (42%) and iron (58%) and having a thickness of about 0.0005 inches (approx. 0.013mm) or about 1 1/2 to 2 times the thickness of a "skin depth" of the particular metal. Each finger 56 may have a reduced thickness such as about 0.006 inches (approx. 0.15mm) after skiving. The solder material of first and second inlays 80,82 may be of Sn 63 having a reflow temperature of about 183°C, and inlays 80,82 may each have a thickness of about 0.002 inches (approx. 0.05mm). Lead frame 50 may finally be formed to have a bend 84 of about 45° where fingers 56 join lateral edge 54 of carrier strip 52, with the ends of the slots 86 between fingers 56 adjacent lateral edge 54 preferably being radiused. Fingers 56 may have a width of 0,010 inches (approx. 0.25mm) where the centerline spacing between traces 94 of circuit element 90 is 0.025 inches (approx. 0,64mm) which must also be the spacing of contact sections 26 of contacts 20 of connector 10. Were the centerline spacing to be 0.100 inches (approx. 2.5mm), fingers 56 and contact sections 26 could have a width of 0.030 inches (approx. 0.8mm); for a spacing of 0.050 inches (approx. 1.30 mm), the fingers and contacts could have a width of 0.17 inches (approx. 0.43 mm).

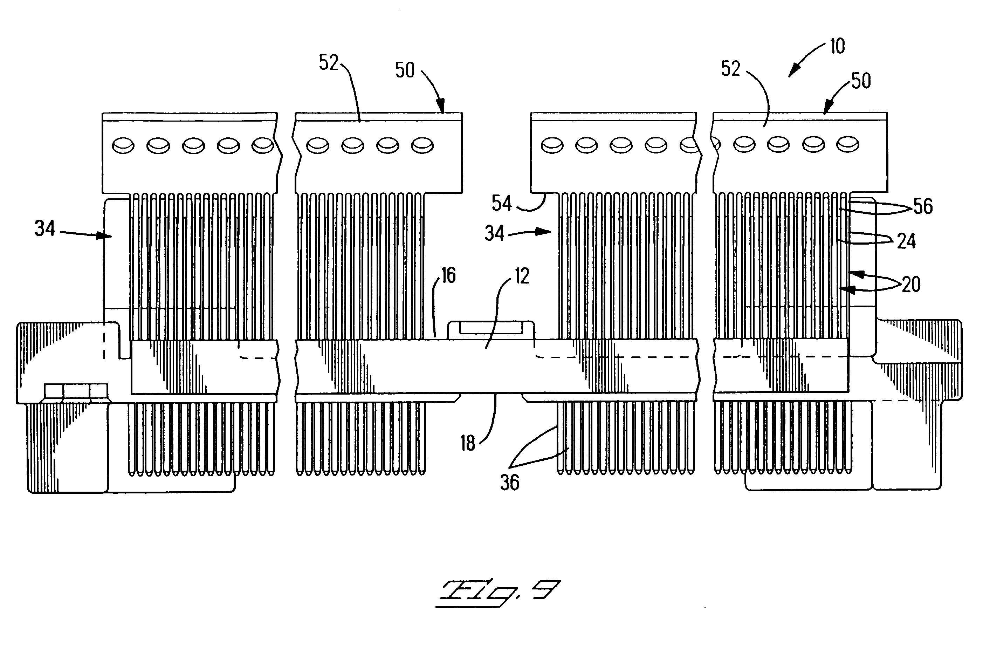

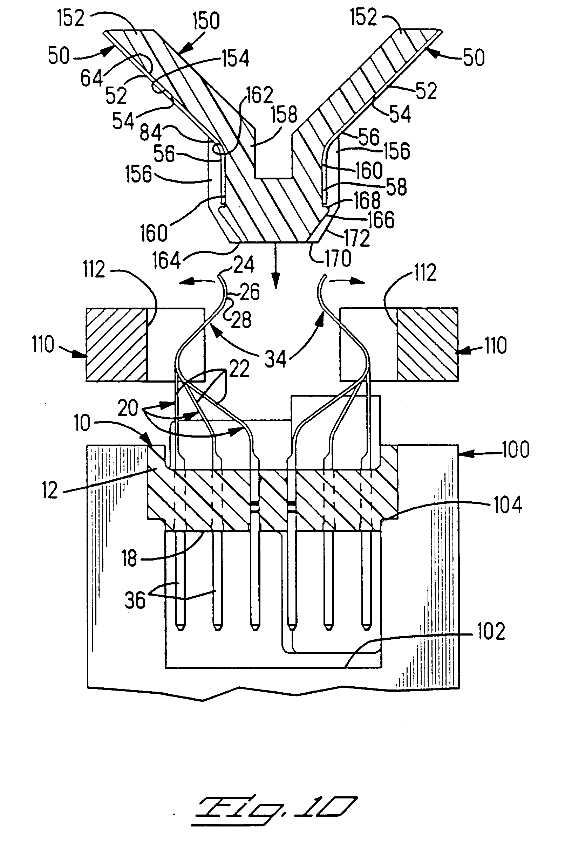

In Figure 7 connector 10 is shown after a lead frame 50 is secured to a representative one of opposing arrays 34, and is then shown in Figure 8 having lead frames along both arrays 34 after being soldered to a circuit element 90 having a trace array 96. Edges of end 92 of circuit element 90 are shown chamfered as is conventional in circuit element manufacture.

In Figure 9 connector 10 is shown having conductor strips 50 soldered to respective arrays 34 of elongate cantilever beam arms 22 of contacts 20. Second contact sections 36 of contacts 20 extend forwardly from mating face 18 of connector 10 for mating with corresponding socket contacts of a mating connector (not shown). Connector 10 is shown fully fabricated and ready to be soldered to a circuit element, having integral alignment maintenance and spacing means, integral heater means and integral solder preform means, all defined by lead frames 50 secured to arms 22 of contacts 20. Connector 10 thus can be shipped to a site remote from its fabrication site in order to be soldered to a circuit element, and is adapted to be resistant to damage to elongate cantilever beam arms during reasonable handling. When connector 10 is fully fabricated, contact sections 26 of opposing arrays 34 are spaced slightly closer together than the thickness of circuit element 90 to be inserted between the arrays when connector 10 is soldered thereto, so that elongate cantilever beam arms apply spring force to contact sections 26 to ultimately generate assured moderate force against traces 94 of circuit element 90 during and after eventual soldering thereto to assist in establishing and maintaining appropriate solder joints therewith.

The method of soldering lead frames 50 to connector 10 is diagrammatically shown in Figures 10 to 13 inclusive which completes its fabrication, and the method of soldering a fully fabricated connector 10 to circuit element 90 is diagrammatically shown in Figures 14 to 16.

In Figure 10, connector 10 is affixed within support tooling 100, nestled within connector-receiving cavity 102. Housing 12 rests on ledges 104 with contact sections 36 and other portions of connector 10 which extend forwardly of mating face 18 depend into the cavity. Comb portions 110 of tooling 100 define grooves 112 into which respective contact arms 22 are carefully received and held during soldering to respective fingers 56 of lead frames 50.

Also in Figure 10, a lead frame 50 is affixed such as by being clamped to each side 152 of a strip support tooling head 150 so that trace-proximate side 64 of carrier strip 52 is disposed adjacent and against an angled surface portion 154 of side 152. The portion of each finger 56 of strip 50 forwardly of bend 84 is disposed within a discrete groove 156 of vertical portion 158 of support tooling 150 and against the bottom groove surface 160, and bend 84 of each finger 56 of strip 50 is nestled in corresponding bend 162 along the bottom surface 160 of groove 156.

Tooling head 150 is preferably formed of thermally insulative material which is dimensionally stable under high temperatures and is also inherently solder resistive along outer surfaces thereof, such as for example titanium or precision molded liquid crystal polymers such as are made by Celanese Specialties Corporation. Tooling head 150 can also be machined from stainless steel which is then oxidized or is coated with titanium nitride or chromate. Especially the side surfaces of grooves 156 and bottom groove surfaces 160 adjacent second solder inlays 82 on fingers 56 (see Figure 6) should be solder resistive. Vertical tooling portion 158 is dimensioned to be about as wide between bottom surfaces 160 of opposed grooves 156 as the thickness of a circuit element 90 to which connector 10 will eventually be soldered.

Referring now to Figures 10 and 11, forward end 164 of vertical portion 158 is preferably adapted to facilitate receipt into respective grooves 156, of contact sections 26 of connector contact arms 22 upon insertion of strip tooling head 150 between arrays 34 of contacts 20. Connector 10 has been fabricated such that contact sections 26 of the opposing arrays 34 are spaced slightly closer together than the thickness of the circuit element for which connector 10 is intended. The process of soldering the lead frames 50 preferably takes advantage of the slightly closer spacing to enhance the soldering of fingers 56 to contact sections 26. Forward tooling end 164 includes beveled surfaces 166 along lateral corners thereof which will facilitate receipt of closer spaced contact sections 26 into grooves 160 by easily initiating outward deflection of free ends 24 of contact arms 22 when free ends 24 engage beveled surfaces 166, and tin-lead plated trace-proximate surfaces 28 bear thereagainst. Free ends 24 continue being deflected outwardly until adjacent small-radiused apices 168 whereat free ends 24 are spread apart just wider than fingers 56 of lead frame 50 are held by vertical tooling portion 158, to pass over finger ends 58 without snagging. Trace-proximate surfaces 28 of contact sections 26 will then engage under moderate spring pressure first solder inlays 80 of fingers 56 (see Figure 6). Flux may now be deposited at each solder site such as by brushing the exposed contact arm free ends 24 with liquid flux such as RMA (rosin, mildly activated).

Even though tooling head 150 will be precisely registered with connector support tooling 100 (by conventional mechanical means not shown) for conductor strips 50 mounted thereon to be correspondingly registered with contact arrays 34, with contact arms 22 within grooves 112 of comb tooling 110 and fingers 56 within grooves 156 of strip tooling head 150, forward end 164 of strip tooling head 150 is preferably further adapted to facilitate receipt of free ends 24 into grooves 156. Leading edges 170 of ribs 172 defining grooves 156 are preferably slightly tapered so that in the event any of free ends 24 engage a leading edge 170 they will be deflected laterally to assuredly enter a respective groove 156 and will not snag.

Referring now to Figure 12, connector 10 and lead frames 50 are positioned to be soldered. With free ends 24 of contact arms 22 now disposed within grooves 156 of strip tooling head 150 adjacent fingers 56, and their lateral positioning now assuredly maintained, comb tooling 110 may now optionally be carefully withdrawn. Arm support tooling 120 is now brought adjacent outer surfaces of contact arms 22 to apply additional pressure on contact sections 26 against solder inlays 80 of fingers 56. Applicator tooling 180 is then brought firmly against trace-remote surface 66 of carrier strip 52 of lead frame 50, thereby being in intimate contact with magnetic layer 72. RF generator 190 generates an alternating high frequency constant amplitude current such as RF current having a frequency of 13.56 Hz, which is transmitted to magnetic layer 72 by applicator tooling 180 for a selected length of time; such an RF generator is disclosed in U. S. Patent No. 4,626,767. Carrier strip 52 in response generates heat until a temperature is achieved equal to the Curie temperature of the magnetic layer for the given frequency. Such RF current can be applied for a short period of time such as seven to ten seconds, to achieve a maximum temperature such as 250°C to melt solder such as Sn 63 having a reflow temperature of about 183°C.

The thermal energy thus generated in response to the RF current is conducted along fingers 56 to solder inlays 80 which then reflow and form solder joints 81 with contact sections 26, as seen in Figure 13. Preferably each lead frame 50 is soldered separately to its associated array 34 of contact sections 26. With strip tooling head 150 being thermally insulative, little thermal energy is drawn away from lead frame 50. With surfaces of tooling head 150 being solder resistive, no solder joints are formed joined thereto when solder inlays 82 are heated, and the melted solder does not wet the tooling surface and flow away from fingers 56; the solder of inlays 82 then resolidifies to remain as defined inlays or preforms. Connector 10 is then cleaned to remove flux.

Connector 10 may now be handled and shipped to another site for assembly to a circuit element; when handled with reasonable care, lead frames 50 secured to arrays 34 of contact arms 22 will maintain the precise original desired spacing and the alignment of elongate cantilever beam arms 22.

In Figure 14, connector 10 is again positioned within a cavity 202 of support tooling 200, similar to tooling 100, on ledges 204 thereof. Insertion of forward end 92 of circuit element 90 between arrays 34 of contact sections 26 is facilitated by use of thin plastic sheets 215 such as of MYLAR polyester film (trademark of E. I. du Pont de Nemours and Company). Incremental lateral movement of circuit element 90 then adjusts the position thereof to precisely register the alignment of the traces thereon with respective contact sections 26, facilitated by thin plastic sheets 215 which prevent snagging of side edges of the fingers of the lead frames 50 or disturbance of the solder inlays with the traces which may protrude incrementally above the surface of circuit element 90. Registration tooling 230 need not comprise a comb needing to be interdigitated with either contact arms 22 or fingers 56; tooling 230 is engaged to maintain the precise relative alignment or registration attained between the arrays of circuit element traces and the arrays 34 of contact sections 26, and then the thin plastic sheets 215 are carefully removed by being withdrawn vertically, after which solder inlays 82 (Figure 6) defined on trace-proximate surfaces 60 of fingers 56 of lead frames 50, will be in engagement with traces 94 (Figures 1 and 8) of the circuit element; traces 94 will conventionally be plated with a coating of tin-lead alloy for enhancement of solder joint formation.

Soldering of connector 10 to circuit element 90 is shown in Figure 15. Once again, contact arms 22 are pressed by support tooling 220 to generate pressure of contact sections 26 against corresponding traces of circuit element 90, and more precisely, of solder inlays 82 (Figure 6) of fingers 56 of lead frame 50 against the traces. On an array-by-array basis, applicator tooling 280 is pressed firmly against trace-remote surface 66 of carrier strip 52 of lead frame 50 in intimate engagement with magnetic layer 72 therealong. (Optionally, carrier strip 52 may be supported by a thermally insulative member, not shown). Flux such as RMA is again preferably added to the solder sites. RF current is generated by RF apparatus 290 and transmitted to carrier strip 52; thermal energy is generated until the known maximum temperature is reached and maintained, and is conducted along fingers 56 to solder inlays 82. RF current such as 13.56 MHz is preferred, for a short period of time such as three to seven seconds, to achieve a maximum temperature such as 250°C to melt solder such as Sn 63 having a reflow temperature of about 183°C. RF generator 290 may be similar to RF generator 190 of Figure 12, for example of the type disclosed in U. S. Patent No. 4,626,767.

The solder of inlays 82 reflows and forms solder joints 83 with traces of the circuit element 90, as seen in Figure 16; the solder of solder joints 81 remains in place and resolidifies to reform solder joints 81. After soldering has been performed, carrier strips 52 may now be removed: preferably a blade-shaped tool 240 is brought against the outwardly facing surface of lead frame 50 between lateral edge 54 of carrier strip 52 and solder joint 83, pinning fingers 56 against circuit element 90 at locations 242 spaced a small distance from solder joint 83; carrier strip 52 is then pivoted back and forth two or three times for example, weakening the metal of thin fingers 56 until fracture occurs, after which carrier strip 52 is removed leaving small remnants 88 of fingers 56 adjacent the surface of circuit element 90, still aligned with respective traces 94 thereon. Connector 10 after soldering to circuit element 90 is again cleaned of flux.

Solder joints 83 and 81 define desired fillets in the areas between the arcuate surfaces and adjacent flat surfaces, or at end edges and side edges of the contact sections, the fingers and the traces, to establish assured electrical connections between the contacts 20 of connector 10 and traces 94 of circuit element 90. Mechanical securement can now be performed of connector housing 12 to circuit element 90 such as with conventional fastener members as disclosed in U. S. Patent No. 4,903,402 and cover members secured therearound to define a line replaceable module, for example. In Figure 16 another embodiment of circuit element 90 is depicted, comprising a printed circuit board having arrays of traces 94 on both major surfaces thereof.

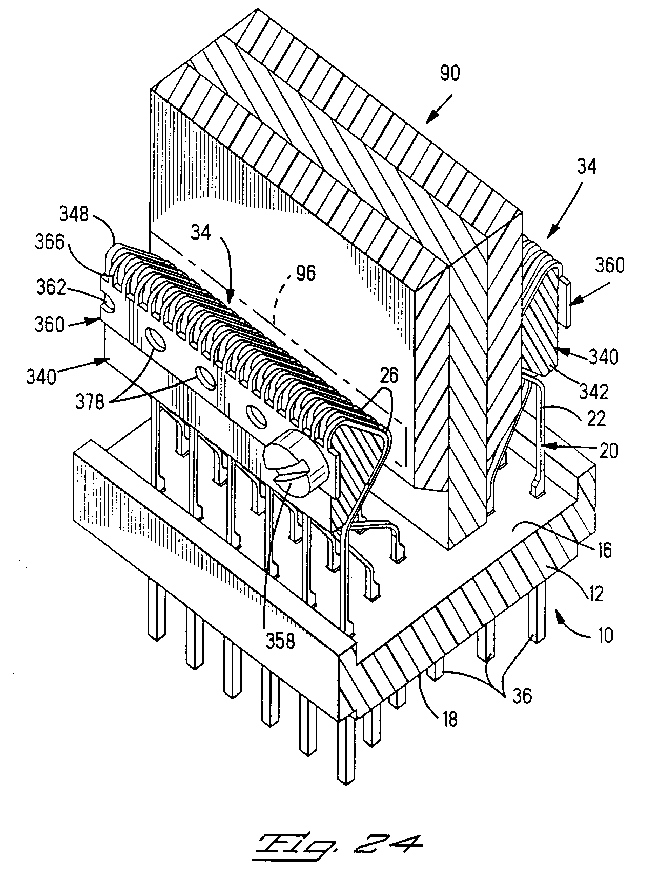

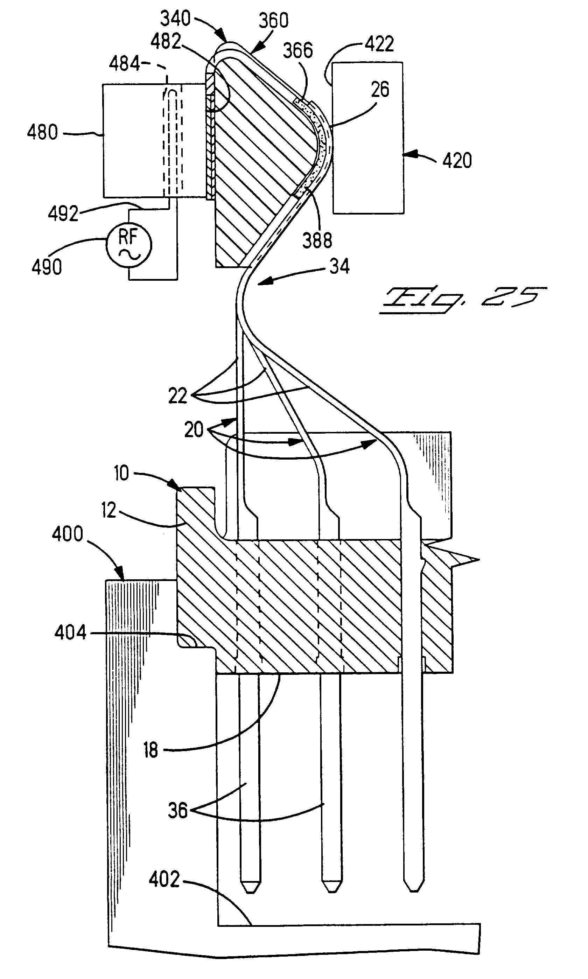

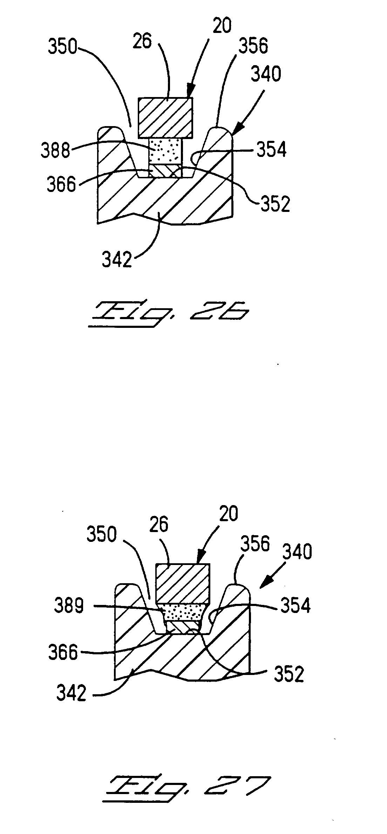

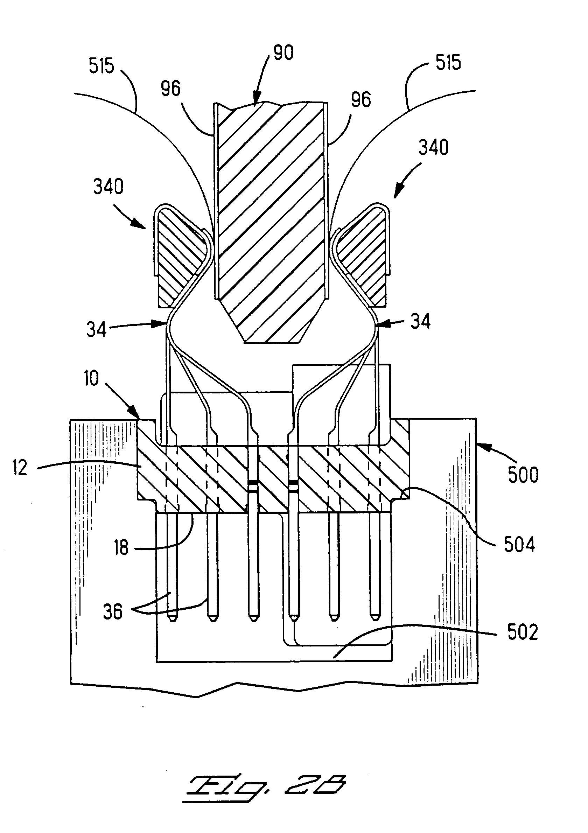

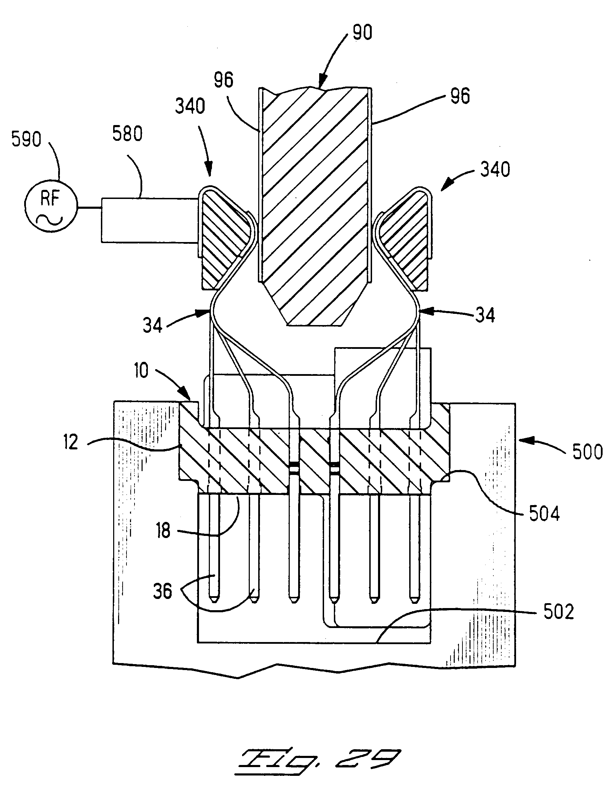

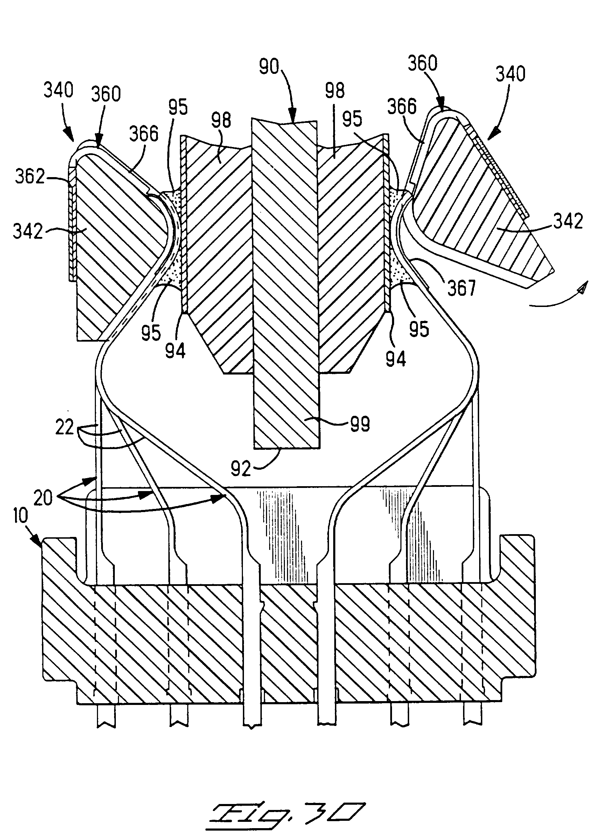

Figures 17 to 22 show a soldering component 340 of a second embodiment of the present invention, comprising a block member 342 of thermally insulative material having solder resistive surfaces, and a lead frame 360 of the present invention secured thereto to outer surfaces thereof, with several such components 340 to be used with a connector 10 such as shown in Figures 1 and 2. After soldering components 340 are secured by soldering to the respective arrays 34, a connector assembly (Figure 25) will be defined which will be ready to be soldered to a circuit element 90. Lead frame 360 is similar to lead frame 50 of Figures 3 to 15. Each lead frame 360 includes a body section 362 outwardly from one lateral edge 364 of which coextend a plurality of fingers 366 to free ends 368. Fingers 366 each are associated with and spaced to correspond with a respective first contact section 26 of an array 34 thereof and have a block-proximate side 370 and a contact-proximate side 372 near free ends 368 thereof; fingers 366 are to be soldered to trace-remote surfaces 38 of contact sections 26. Body section 362 can be said to have a block-proximate surface 374 and a block-remote surface 376, and also includes a plurality of regularly spaced registration holes 378.

In Figure 18 body section 362 and fingers 366 are initially stamped as an integral member from a thin strip of low resistance metal such as a copper alloy, and the copper alloy of body section 362 will be referred to as first layer 380; a second layer 382 of magnetic material is disposed along block-remote surface 376 of first layer 380 of body section 362 in intimate bonded relationship with first layer 380 such as is attainable with known methods of cladding a thin layer of metal to a metal surface. Preferably second layer 382 is incrementally thin and is disposed within a skived recess 384 of body section 362. Each finger 366 is shown to have a reduced thickness by being skived on contact-proximate side 372 to define a solder recess 386 in which solder material is deposited to form an inlay or preform 388, such as by roll cladding or electrodeposition. Skiving preferably is performed before lead frame 360 is stamped from a continuous strip of copper alloy after which the surfaces of at least the fingers should be nickel underplated; also, skiving and stamping may be performed on a strip of double width thus creating a pair of continuous lead frames simultaneously which may subsequently be severed across the still-joined fingers to define ends 368.

In Figures 19 to 22 after the magnetic material and the solder preforms are defined on lead frame 360, lead frame 360 is secured to block member 342. The outer surface of block member 342 includes a substantially planar first surface 344 extending along the length thereof to eventually face away from arrays 34 of contact arms 22, and a second surface 346 extending arcuately about the circumference of block member 342 from a radiused bend 348 along the longitudinal edge of first surface 344. Second surface 346 includes an array of grooves 350 extending about the circumference from radiussed bend 348 located to correspond with the spacing of the contact arms 22 of array 34 of connector 10.

Body section 362 is disposed along planar first surface 344 of block 342, and conventional fasteners 358 may be used to be inserted through registration holes 378 of body section 362 and threaded into apertures of block member 342. Elongate fingers 366 are then bent around radiused bend 348 and then carefully wiped (such as by a comb, not shown) into respective grooves 350 spaced to correspond to contact arms 22 of array 34 of connector 10. Grooves 350 have tapered side walls 354 extending outwardly from bottom surface 352 and are wider between ridges 356 than respective contact arms 22 in order that arms 22 are received thereinto, and grooves 350 further have a depth sufficient for fingers 366 with solder preforms 388 therein to be disposed along groove bottoms 352 and additionally for part of the thickness of contact arms 22 to fit therewithin atop solder preforms 388, all as best seen in Figures 26 and 27.

Block member 342 is preferably formed of thermally insulative material which is dimensionally stable under high temperatures, such as for example liquid crystal polymers such as are sold by Celanese Specialties Corporation. Such materials will preferably inherently form the necessary solder resistive surfaces especially at side surfaces 354 and bottom surfaces 352 of grooves 350 proximate solder preforms 388 on fingers 366.

Lead frame 360 may be fabricated from strip stock of a low resistance, low magnetic permeability metal such as brass or Copper Alloy C21000 of beryllium copper and having a thickness of about 0.010 inches (approx. 0.25mm) before skiving. Second layer 382 is of a metal which has high magnetic permeability and high resistance, the second layer for example being Alloy No. A-42 of nickel (42%) and iron (58%) and having a thickness of about 0.0005 inches (approx. 0.013mm) or between about 1½ to 2 times the thickness of a "skin depth" of the particular metal. Each finger 366 may have a reduced thickness such as about 0.003 inches (approx. 0.076 mm) after skiving. The solder material of preforms 388 may be of Sn 63 having a reflow temperature of about 183°C, and preforms 388 may have a thickness of about 0.007 inches (approx.0.18mm). Contact arms 32 may have a width of about 0.008 inches (approx. 0.2mm) and fingers 366 may have a width of 0.006 inches (approx.0.15mm) where the traces 94 of circuit element 90 may be about 0.012 inches(approx. 0.3mm) wide while the trace centerline spacing between traces 94 is 0.025inches(approx.0.64mm),which must also be the centerline spacing of contact sections 26 of contacts 20 of connector 10 and of fingers 366. Were the centerline spacing to be 0.100 inches(approx.2.5mm) contact sections 26 could have a width of 0.030 inches (approx.0.76mm) and the fingers slightly less; for a spacing of 0.050 inches (approx.1.3mm), the contacts could have a width of 0.017 inches(approx.0.43mm) and the fingers slightly less.

Figure 25 illustrates connector 10 having soldering components 340 secured along trace-remote surfaces 38 of contact sections 26 of contact arm arrays 34. Second contact sections 36 of contacts 20 extend forwardly from mating face 18 of connector 10 for mating with corresponding socket contacts of a mating connector (not shown). Connector 10 as assembled with soldering components 340 is now ready to be soldered to a circuit element, having integral alignment maintenance and spacing means, integral heater means and integral solder preform means, all defined by lead frames 360 with fingers 366 in grooves 350 and secured to arms 22 of contacts 20. Connector 10 thus can be shipped to a site remote from its manufacturing site in order to be soldered to a circuit element, and is adapted to be resistant to damage to elongate cantilever beam arms during reasonable handling. When connector 10 is fully fabricated, contact sections 26 of opposing arrays 34 are spaced slightly closer together than the thickness of circuit element 90 to be inserted between the arrays when connector 10 is soldered thereto, so that elongate cantilever beam arms 22 apply spring force to contact sections 26 to ultimately generate assured moderate force against traces 94 of circuit element 90 during and after eventual soldering thereto to assist in establishing and maintaining appropriate solder joints therewith.

Figure 23 illustrates connector 10 fully manufactured with soldering components 340 soldered to opposing arrays 34 and ready to be soldered to a circuit element. Figure 24 illustrates connector 10 after being soldered to circuit element 90 having trace arrays 96. Soldering components 340 may now be carefully manipulated and removed from connector 10 now soldered to circuit element 90.

The method of securing soldering components 340 to connector 10 is diagrammatically shown in Figure 28 which completes its fabrication, and the method of soldering a fully fabricated connector 10 to circuit element 90 is diagrammatically shown in Figures 29 and 30.

In Figure 25, connector 10 is affixed within support tooling 400, nestled within connector-receiving cavity 402. Housing 12 rests on ledges 404 with contact sections 36 and other portions of connector 10 which extend forwardly of mating face 18 depend into the cavity. Contact arms 22 have been received into respective grooves 350 of block member 342 of soldering component 340 by soldering component 340 being moved carefully thereagainst, and contact arms 22 being carefully wiped thereinto and held therewithin by support tooling 420 whose surface 422 may for example be of felt material which will safely engage trace-proximate surfaces of contact sections 26 with slight friction during incremental lateral movement of tooling 420 to finally seat all contact arms in respective grooves 350. Support tooling 420 enables soldering component 340 to apply pressure on contact sections 26 against solder preforms 388 of fingers 366 during soldering. Flux may now be deposited at each solder site such as by brushing the exposed contact arm free ends 24 with liquid flux such as RMA (rosin, mildly activated).

Applicator tooling 480 is then brought firmly against trace-remote surface 376 of body section 362 of lead frame 360, so that surface 482 is in intimate contact with magnetic layer 382; surface 482 may comprise a plurality of projections to minimize draining heat from soldering component 340. Applicator tooling 480 may be made of polytetrafluoroethylene, for example. RF generator 490 may be of the type having a coil 492 disposed within an aperture 484 of applicator tooling 480 proximate surface 482. Applicator tooling 480 may also conveniently be used to apply pressure on soldering components 340 to generate compression against contact sections 26 to facilitate and assure effective soldering.

RF generator 490 generates an alternating high frequency constant amplitude current such as RF current having a frequency of 13.56 MHz, which is transmitted to magnetic layer 382 by applicator tooling 480 for a selected length of time; such an RF generator is disclosed in U.S. Patent No. 4,626,767. Body section 362 in response generates heat until a temperature is achieved equal to the Curie temperature of the magnetic layer for the given frequency. Such RF current can be applied for a very short period of time such as three to five seconds, to achieve a maximum temperature such as 250°C to melt solder such as Sn 63 having a reflow temperature of about 183°C, sufficient to define joints for mechanical attachment to contact arms 22.

The thermal energy thus generated in response to the RF current is conducted along fingers 366 to solder preforms 388 which then reflow and form solder joints 389 with contact sections 26, as seen in Figure 27. Soldering components 340 may be soldered simultaneously or separately to their associated arrays 34 of contact sections 26. With block member 342 being thermally insulative, little thermal energy is drawn away from lead frame 360. With surfaces of block member 342 being solder resistive, no solder joints are formed joined thereto when solder preforms 388 are heated, and the melted solder does not wet the block surface and flow away from fingers 366 or contact sections 26; the solder of preforms 388 then resolidifies into deposits at joints 389 adjacent contact sections 26 and fingers 366, although some flowing may occur about the side edges of contact arms 22 and of fingers 366. Connector 10 is then cleaned to remove flux.

Connector 10 may now be handled and shipped to another site for assembly to a circuit element; when handled with reasonable care, soldering components 340 secured to arrays 34 of contact arms 22 will maintain the precise original desired spacing and the alignment of elongate cantilever beam arms 22.

In Figure 28, for being soldered to a circuit element 90, connector 10 is again positioned within a cavity 502 of support tooling 500, similar to tooling 400, on ledges 504 thereof. Connector 10 has been fabricated such that contact sections 26 of the opposing arrays 34 are spaced slightly closer together than the thickness of the circuit element for which connector 10 is intended. Insertion of forward end 92 of circuit element 90 between arrays 34 of contact sections 26 is facilitated by use of thin plastic sheets 515 such as of MYLAR polyester film (trademark of E. I. du Pont de Nemours and Company). Incremental lateral movement of circuit element 90 then adjusts the position thereof to precisely register the alignment of the traces thereon with respective contact sections 26, facilitated by thin plastic sheets 515 which prevent snagging of side edges of the fingers of the lead frames 360 or disturbance of the solder preforms with the traces which may protrude incrementally above the surface of circuit element 90.

Although certain tooling or fixtures is preferably to be utilized in holding and positioning the connector and the circuit element relative to each other, such tooling need not comprise a comb needing to be interdigitated with contact arms 22 to attain realignment and respacing thereof to correspond with the traces of the circuit element array. The contact arm arrays of the connector are incrementally movable as integral units to attain precise registration with the circuit element traces, and then the thin plastic sheets 215 are carefully removed by being withdrawn vertically, after which trace-proximate surfaces 28 of contact arms 22 will be in engagement with traces 94 of arrays 96 (Figures 1 and 24) of the circuit element; traces 94 will conventionally be plated with a coating of tin-lead alloy for enhancement of solder joint formation.

Soldering of connector 10 to circuit element 90 is shown in Figure 29. Applicator tooling 580 and RF generator 590 may be similar to applicator tooling 480 and RF generator 490 of Figure 25, and as with attachment of soldering component 340 to connector 10, may be applied to both components along both arrays to solder both sides of circuit element 90 simultaneously, if desired. Applicator tooling 580 is pressed firmly against the trace-remote surface of the body section of lead frame 360 in intimate engagement with the magnetic layer therealong. Flux such as RMA is again preferably added to the solder sites. RF current is generated by RF apparatus 590 and transmitted to the body section of lead frame 360; thermal energy is generated until the known maximum temperature is reached and maintained, and is conducted along fingers 366 to resolidified solder preforms 388. RF current such as 13.56 ^{M}Hz is preferred, for a short period of time such as three to seven seconds, to achieve a maximum temperature such as 250°C to melt solder such as Sn 63 having a reflow temperature of about 183°C.

The solder of deposits at joints 389 (Figure 27) again reflows to flow or wick about side edges of contact arm free ends 24 together with now-molten tin-lead plating on traces 94 to form solder joints 95 with the traces of the circuit element 90, as seen in Figure 30. After soldering has been performed, block member 342 may now be removed by being pivoted back and forth about the free ends of the contact arms 22 two or three times for example, weakening the metal of thin fingers 366 adjacent the ends of the contact arm free ends until fracture occurs, after which block member 342 with body section 362 is removed leaving innocuous small remnants 367 of fingers 366 soldered to the trace-remote surfaces 38 of contact sections 26 of connector contacts 20.

Solder joints 95 define desired fillets in the areas between the arcuate surfaces and adjacent flat surfaces, or at end edges and side edges of the contact sections, the fingers and the traces, to establish assured electrical connections between the contacts 20 of connector 10 and traces 94 of circuit element 90. Connector 10 after soldering to circuit element 90 is again cleaned of flux. Additional mechanical securement may be utilized to assuredly secure connector housing 12 to circuit element 90 such as with conventional fastener members as disclosed in U.S. Patent No. 4,903,402 and cover members secured therearound to define a line replaceable module, for example.

As shown in Figure 30, soldering components 340 may now be carefully manipulated and removed from connector 10 now soldered to circuit element 90. Block member 342 may now be pivoted back and forth about the end of free ends 28 of contact arms 22, which are now soldered at joints 95 to respective traces 94, which process breaks thin fingers 366 at locations spaced from solder joints 95. Remnants 367 of fingers 366 remain soldered along trace-remote sides of contact sections 26 of connector contacts 20 and are now innocuous.

Since the thermal energy generated by carrier strips 52 or components 340 is transmitted only to the discrete solder sites, and only to a known carefully selected maximum temperature, and only for a very brief time period, the remainders of both connector 10 and circuit element 90 are now generally protected from substantial amounts of thermal energy, and circuit element 90 is able to be loaded, prior to securing the connector thereon, with electrical and electronic components whose solder joints to the element will not be affected by high temperatures. Also, optical devices such as light emitting and light detecting devices may be previously mounted thereon along with fiber optic cables having terminals on ends thereon to be inserted into corresponding passageways of connector 10 for transmission of optical signals to and from the circuit element.

Lead frames 50 and soldering components 340 assist not only the maintenance of spacing and alignment of elongate contact arms 22 but also the delivery of defined solder portions 82 to specific sites, are useful in yet another valuable way: to enable the generation of thermal energy at only the solder sites, which isolates the remainder of the circuit element and the connector from the degrading effects of high temperature and greatly simplifies the soldering process, in addition to the presoldering handling and eliminates the need for expensive and elaborate conventional tooling previously required therefor to realign and precisely space the contact arm free ends.

There may occur various modifications to the method disclosed hereinabove and to the soldering components of the present invention which will be within the scope of the claims. For example, tooling head 150 which supports lead frames 50 during soldering to contact arm arrays 34 of connector 10 (Figures 10 to 12), can optionally be fabricated to be flexed or "collapsed" or disassembled, all to facilitate being withdrawn from between arrays 34 after lead frames 50 are soldered thereto, without disturbing connector 10.

## Claims

1. A method of securing an electrical connector (10) to a circuit element (90), the connector of the type having at least one array of elongate contact arms (20) extending from a mounting face (16) to free ends (24) defining contact sections (28) disposed in a common plane for being soldered to a corresponding array of conductive means (94) defined on a common surface of the circuit element (90) to establish a plurality of electrical and mechanical connections between the connector and the circuit element, comprising the steps of:
a) providing a source for generating a constant amplitude high frequency alternating current of known frequency;
b) securing to said contact arm free ends (24) of said connector (10) a lead frame (50,360) having a plurality of fingers (56, 366) each in registration with and joined to a respective said contact arm free end (24) and having respective amounts of solder material (80,388) secured thereto sufficiently near to said contact arm free ends (24) to be sufficiently near to trace-proximate surfaces (28) thereof to flow thereonto during soldering,
c) said lead frame (50,360) further including a carrier strip section (52,362) defining an integral Curie point heater means (70,72; 380,382) adapted to generate thermal energy until achieving a known maximum selected temperature when subjected to said current of known frequency for a selected length of time, and
d) said lead frame (50,360) integrally maintaining the spacing of said contact arm free ends (24) after said joining;
e) placing said circuit element (90) adjacent said trace proximate surfaces (28) of said contact arm free ends (24) with said conductive means (94) in registration therewith;
f) generating said constant amplitude high frequency alternating current in said heater means (70,72;380,382) for said selected length of time; and
g) removing at least said carrier strip section (52,362) from said fingers (56,366) of said lead frame, thereby defining discrete electrical circuits.

2. The method of claim 1, characterized in that said step of removing said carrier strip section (52) of each said lead frame (50) includes at least
a) clamping said lead frame against an adjacent major surface portion of said circuit element by a sharp-edged tool (240) at a location along said fingers (56) between said carrier strip section (52) and said soldered connections (83) of said contact arm free ends (24) to respective said conductive means and
b) manipulating said carrier strip section (52) outwardly of said location to weaken and break said fingers (56) thereat.

3. The method of claim 1 or 2 characterized in that
a) said circuit element (90) includes arrays of said conductive means (94) on both major surfaces (98) thereof to be electrically connected to opposed arrays (34) of contact arm free ends (24) of said connector (10), and
b) said circuit element (90) is inserted between said opposed arrays (34) prior to soldering,
c) said method further including at least prior to circuit element soldering, the step of forming said opposed arrays (34) of contact arm free ends to be spaced apart a distance slightly less than the thickness of said circuit element to which said connector is to be soldered.

4. The method of claiml or 2, further including the steps, prior to said securing step, of:
a) forming an elongate block member (342) of thermally insulative material having a solder resistive outer surface, said outer surface having a first portion (344) and a second portion (346), said first portion being substantially planar and extending along said block member, and said second portion being smoothly arcuate and adjoining said first portion along a lateral edge thereof an array of grooves (350) corresponding to said array of contact arms (20) being defined in said second portion extending transversely from said first portion (344) and across said second portion (346); and
b) securing said lead frame (360) on said outer surface of said block member (342) with said carrier strip section (362) being secured to and along said first surface portion (344), and said fingers (366) being disposed along bottom surfaces (352) of respective said grooves (350), defining a soldering components (340); and
c) said step of securing said lead frame (360) to said contact arm free ends (24) comprises positioning said soldering component (340) adjacent trace-remote surfaces (38) of free ends (24) of a respective said contact arm array such that said contact arm free ends (24) are receiving into respective said grooves (350) and said end portions of said fingers (366) are registered with and against respective ones of said contact sections (28), and such that said carrier strip section (362) faces away from said contact arm array.

5. A lead frame (50) for use in facilitating the soldering of an array (34) of free ends (24) of contact arms (22) of an electrical connector (10) to a corresponding array of conductive means of a circuit element (90), usable in conjunction with a source of constant amplitude high frequency alternating current of known frequency, comprising:
a) an integral member formed from a strip of a first metal having low electrical resistance and minimal magnetic permeability, said integral member defining a first layer (70) having a carrier strip section (52) and a plurality of fingers (56) coextending from said carrier strip section each associated with and spaced to correspond with respective ones of said free ends (24) of said contact arms (22) of said array (34);
b) said carrier strip section (52) having defined on a major surface (66) hereof and integrally joined to said first layer (70) thereof a second layer (72) of a second metal having high electrical resistance and high magnetic permeability, said second layer having a thickness at least equal to one skin depth of said second metal, given said known frequency, said carrier strip section (52) thereby defining a heater means integral to said lead frame (50); and
c) each said finger (56) having solder material (80,82) containing flux therein disposed at least on opposed major surfaces (60,62) thereof at least proximate free ends (58) thereof, defining solder preforms (80,82), said solder material having a nominal reflow temperature slightly less than the Curie temperature of said second metal,
d) whereby a lead frame (50) is defined securable to said contact arm free ends (24) enabling said connector (10) to be soldered to said circuit element (90) without individually realigning and respacing said contact arm free ends in registration with said circuit element conductive means (94) prior to soldering requiring tooling which must be especially adapted therefore, or for placing solder amounts at said joint sites or for subjecting the entire circuit element and connector to high temperatures necessary to otherwise reflow the solder material;
characterized in that
e) said integral member is skived to define a recess (76 or 78) extending inwardly from ends (58) of said fingers (56) along at least one surface (62 or 60) thereof within which solder material is disposed.

6. The lead frame (50) as set forth in claim 5, characterized in that an array of precisely spaced and dimensioned holes (68) are stamped into and along said carrier strip section defining means to move said lead frame (50) to register said fingers (56) with respective said contact arm free ends (24) during the process of securing said lead frame (50) to said array of contact arm free ends (24).

7. The lead frame (50) as set forth in claim 5, characterized in that
a) said integral member is formed to define a bend (84) along the fingers at a location spaced slightly from said carrier strip section (52), and
b) said solder preforms (80,82) extend at least to said bend (84),
c) said integral member is bent in a direction towards said carrier strip section surface (66) on which said second layer (72) is defined, and
d) said integral member is skived to define a recess extending inwardly from ends (58) of said fingers (56) and along a said major surface (60) opposed from that on which said second layer (72) is defined, and
e) extending around said bend a slight distance, within which an amount of said solder material is disposed to define a said preform (82).

8. A soldering component (340) for use in facilitating the soldering of an array of free ends (24) of contact arms (20) of an electrical connector (10) to a corresponding array of conductive means (94) of a circuit element (90), usable in conjunction with a source of constant amplitude high frequency alternating current of known frequency and a lead frame (360) having an elongate body section (362) and transversely extending therefrom a plurality of fingers (366) each in registration with and joined to a respective said contact arm free end (24) and having respective amounts of solder material (388) secured thereto at least proximate trace-remote surfaces (38) of said contact arm free ends (24), the body section (362) defining an integral Curie point heater means adapted to generate thermal energy until achieving a known maximum selected temperature when subjected to said current of known frequency for a selected length of time, said soldering component (340) comprising:
a) an elongate block member (342) of thermally insulative material having a solder resistive outer surface, said outer surface having a first portion (344) and a second portion (346),
aa) said first portion being substantially planar and extending along said block, and
ab) said second portion being circumferentially arcuate and adjoining said first portion along a lateral edge thereof,
b) an array of grooves (350) corresponding to said array of contact arms (20) being defined in said second portion (346) extending transversely from said edge of said first portion (344) and across said second portion (346);
c) said lead frame (360) being secured to said outer surface of said block member (342) with said body section (362) being secured to and along said first surface portion (344), and
d) said fingers (366) being elongate and being formed to be disposed along bottom surfaces (352) of respective said grooves (350);
e) whereby a soldering component (340) is defined securable to said contact arm free ends (24) enabling said connector (10) to be soldered to said circuit element (90) without individually realigning and respacing said contact arm free ends in registration with said circuit element conductive means (94) prior to soldering requiring tooling which must be especially adapted therefor, or for placing solder amounts at said joint sites or for subjecting the entire circuit element and connector to high temperatures necessary to otherwise reflow the solder material.

9. The soldering component (340) as set forth in claim 8 characterized in that
a) said grooves (350) of said block member (342) have angled side walls (354) to have widened entrances therealong,
b) whereby said grooves (350) are adapted to receive thereinto respective ones of said contact arm free ends (24) upon positioning said soldering component (340) adjacent said contact arm array.

## Patentansprüche

1. Verfahren zum Befestigen eines elektrischen Verbinders (10) an einem Schaltungselement (90), wobei es sich bei dem Verbinder um einen des Typs handelt, der wenigstens eine Anordnung länglicher Kontaktarme (20) aufweist, die sich von einer Befestigungsseite (16) zu freien Enden (24) erstrecken, die in einer gemeinsamen Ebene angeordnete Kontaktabschnitte (28) zum Verlöten mit einer entsprechenden Anordnung leitfähiger Einrichtungen (94) definieren, die auf einer gemeinsamen Oberfläche des Schaltungselements (90) definiert sind, um dadurch eine Vielzahl elektrischer und mechanischer Verbindungen zwischen dem Verbinder und dem Schaltungselement herzustellen, wobei das Verfahren folgende Schritte umfaßt:
a) Bereitstellen einer Quelle zum Erzeugen eines Hochfrequenz-Wechselstroms mit konstanter Amplitude und bekannter Frequenz;
b) an den freien Enden (24) Kontaktarme des Verbinders (10) erfolgendes Befestigen eines Leiterrahmens (50, 360), der eine Vielzahl von Fingern (56, 366) jeweils in Ausrichtung mit und in Verbindung mit einem jeweiligen freien Ende (24) der Kontaktarme aufweist und an dem jeweilige Mengen von Lötmaterial (80, 388) ausreichend nahe bei den freien Enden (24) der Kontaktarme befestigt sind, damit dieses nahe genug bei Leiterbahnen benachbarten Flächen (28) derselben angeordnet ist, um während des Lötvorgangs auf diese zu fließen,
c) wobei der Leiterrahmen (50, 360) ferner einen Trägerstreifenabschnitt (52, 362) aufweist, der eine integrale Curiepunkt-Heizeinrichtung (70, 72; 380, 382) bildet, die zur Erzeugung von Wärmeenergie bis zum Erreichen einer bekannten maximalen ausgewählten Temperatur ausgelegt ist, wenn sie dem Strom bekannter Frequenz für eine ausgewählte Zeitdauer ausgesetzt wird, und
d) wobei der Leiterrahmen (50, 360) die Beabstandung der freien Enden (24) der Kontaktarme nach der Verbindung in integraler Weise beibehält;
e) Plazieren des Schaltungselements (90) angrenzend an die den Leiterbahnen benachbarten Flächen (28) der freien Enden (24) der Kontaktarme, wobei die leitfähigen Einrichtungen (94) damit ausgerichtet werden;
f) Erzeugen des Hochfrequenz-Wechselstroms mit konstanter Amplitude in der Heizeinrichtung (70, 72; 380, 382) für die ausgewählte Zeitdauer; und
g) Entfernen von wenigstens dem Trägerstreifenabschnitt (52, 362) von den Fingern (56, 366) des Leiterrahmens, um dadurch einzelne elektrische Schaltungen zu bilden.

2. Verfahren nach Anspruch 1,
dadurch gekennzeichnet, daß der Schritt des Entfernens des Trägerstreifenabschnitts (52) jedes Leiterrahmens (50) wenigstens folgende Schritte umfaßt:
a) Klemmen des Leiterrahmens gegen einen angrenzenden Hauptflächenbereich des Schaltungselements mittels eines scharfkantigen Werkzeugs (240) an einer Stelle entlang der Finger (56) zwischen dem Trägerstreifenabschnitt (52) und den Lötverbindungen (83) der freien Enden (24) der Kontaktarme mit den jeweiligen leitfähigen Einrichtungen, und
b) Betätigen des außerhalb von der genannten Stelle gelegenen Trägerstreifenabschnitts (52) zum Schwächen und Brechen der Finger (56) an dieser Stelle.

3. Verfahren nach Anspruch 1 oder 2,
dadurch gekennzeichnet,
a) daß das Schaltungselement (90) Anordnungen der leitfähigen Einrichtungen (94) auf seinen beiden Hauptflächen (98) zur elektrischen Verbindung mit gegenüberliegenden Anordnungen (34) der freien Enden (24) der Kontaktarme des Verbinders (10) aufweist, und
b) daß das Schaltungselement (90) vor dem Lötvorgang zwischen die einander gegenüberliegenden Anordnungen (34) eingeführt wird,
c) wobei das Verfahren ferner wenigstens vor dem Verlöten des Schaltungselements den Schritt der Ausbildung der einander gegenüberliegenden Anordnungen (34) der freien Enden der Kontaktarme in einer derartigen Weise beinhaltet, daß diese in einer Distanz voneinander beabstandet sind, die geringfügig geringer ist als die Dicke des Schaltungselements, mit dem der Verbinder verlötet werden soll.

4. Verfahren nach Anspruch 1 oder 2,
weiterhin mit folgenden Schritten vor dem Befestigungsschritt:
a) Bilden eines länglichen Blockelements (342) aus wärmeisolierendem Material mit einer lötmaterialabweisenden Außenfläche, wobei die Außenfläche einen ersten Bereich (344) und einen zweiten Bereich (346) aufweist, wobei der erste Bereich im wesentlichen planar ist und sich das Blockelement entlangerstreckt und wobei der zweite Bereich sanft gerundet ist und an den ersten Bereich entlang einer Seitenkante desselben angrenzt, wobei eine Anordnung von Nuten (350), die der Anordnung der Kontaktarme (20) entspricht, in dem zweiten Bereich definiert ist, die sich quer von dem ersten Bereich (344) weg sowie über den zweiten Bereich (346) erstrecken; und
b) Befestigen des Leiterrahmens (360) an der Außenfläche des Blockelements (342), wobei der Trägerstreifenabschnitt (362) an dem ersten Flächenbereich (344) sowie diesen entlang befestigt wird und wobei die Finger (366) entlang von Bodenflächen (352) der jeweiligen Nuten (350) angeordnet werden, wodurch eine Lötkomponente (340) gebildet wird; und
c) wobei der Schritt der Befestigung des Leiterrahmens (360) an den freien Enden (24) der Kontaktarme die Positionierung der Lötkomponente (340) angrenzend an die von den Leiterbahnen abgelegenen Flächen (38) der freien Enden (24) einer jeweiligen Kontaktarmanordnung in einer derartigen Weise beinhaltet, daß die freien Enden (24) der Kontaktarme in den jeweiligen Nuten (350) aufgenommen werden und die Endbereiche der Finger (366) mit den jeweiligen Kontaktabschnitten (28) ausgerichtet werden und an diesen anliegen, sowie derart, daß der Trägerstreifenabschnitt (362) von der Kontaktarmanordnung wegweist.

5. Leiterrahmen (50) zur Verwendung beim Erleichtern des Verlötens einer Anordnung (34) freier Enden (24) von Kontaktarmen (22) eines elektrischen Verbinders (10) mit einer entsprechenden Anordnung leitfähiger Einrichtungen eines Schaltungselements (90), wobei der Leiterrahmen in Verbindung mit einer Quelle eines Hochfrequenz-Wechselstroms mit konstanter Amplitude und bekannter Frequenz ausgelegt ist und folgendes aufweist:
a) ein integrales Element, das aus einem Streifen aus einem ersten Metall mit niedrigem elektrischen Widerstand und minimaler magnetischer Permeabilität gebildet ist, wobei das integrale Element eine erste Schicht (70) mit einem Trägerstreifenabschnitt (52) sowie eine Vielzahl von Fingern (56) bildet, die sich erstreckungsgleich von dem Trägerstreifenabschnitt wegerstrecken und deren jeder einem jeweiligen freien Ende (24) der Kontaktarme (22) der Anordnung (34) zugeordnet ist und diesen entsprechend beabstandet ist;
b) wobei auf einer Hauptfläche (66) des Trägerstreifenabschnitts (52) sowie in integraler Verbindung mit der ersten Schicht (70) desselben eine zweite Schicht (72) aus einem zweiten Metall mit hohem elektrischen Widerstand und hoher magnetischer Permeabilität gebildet ist, wobei die zweite Schicht eine Dicke aufweist, die wenigstens einer Eindringtiefe des zweiten Metalls bei der gegebenen, bekannten Frequenz entspricht, wodurch der Trägerstreifenabschnitt (52) eine mit dem Leiterrahmen (50) integrale Heizeinrichtung bildet; und
c) wobei jeder Finger (56) Flußmittel enthaltendes Lötmaterial (80, 82) wenigstens auf einander gegenüberliegenden Hauptflächen (60, 62) desselben zumindest in der Nähe seiner freien Enden (58) aufweist, das Lötmaterial-Vorformen (80, 82) bildet, wobei das Lötmaterial eine nominale Wiederverflüssigungstemperatur aufweist, die geringfügig niedriger ist als die Curietemperatur des zweiten Metalls,
d) wodurch ein Leiterrahmen (50) gebildet ist, der an den freien Enden (24) der Kontaktarme befestigbar ist und ein Verlöten des Verbinders (10) mit dem Schaltungselement (90) ohne individuelle Neuausrichtung und Neubeabstandung der freien Enden der Kontaktarme in Ausfluchtung mit den leitfähigen Einrichtungen (94) des Schaltungselements vor dem Verlöten unter Erfordernis von speziell dafür ausgelegten Werkzeugeinrichtungen oder zum Plazieren von Lötmaterialmengen an den Verbindungsstellen oder zum Aussetzen des gesamten Schaltungselements und des Verbinders gegenüber hohen Temperaturen, die ansonsten zur Wiederverflüssigung des Lötmaterials erforderlich sind, ermöglicht;
dadurch gekennzeichnet,
e) daß das integrale Element zur Bildung einer Ausnehmung (76 oder 78) abgetragen ist, die sich von den Enden (58) der Finger (56) entlang wenigstens einer Oberfläche (62 oder 60) derselben in Richtung nach innen erstreckt und in der Lötmaterial angeordnet ist.

6. Leiterrahmen (50) nach Anspruch 5,
dadurch gekennzeichnet, daß eine Anordnung exakt voneinander beabstandeter und dimensionierter Löcher (68) den Trägerstreifenabschnitt entlang in diesen eingestanzt ist, wodurch eine Einrichtung zum Bewegen des Leiterrahmens (50) zum Ausrichten der Finger (56) mit den jeweiligen freien Enden (24) der Kontaktarme während des Vorgangs der Befestigung des Leiterrahmens (50) an der Anordnung der freien Enden (24) der Kontaktarme gebildet ist.

7. Leiterrahmen (50) nach Anspruch 5,
dadurch gekennzeichnet,
a) daß das integrale Element derart geformt ist, daß es eine Biegung (84) entlang der Finger an einer Stelle bildet, die von dem Trägerstreifenabschnitt (52) geringfügig beabstandet ist, und
b) daß die Lötmaterialvorformen (80, 82) sich wenigstens bis zu der Biegung (84) erstrecken,
c) daß das integrale Element in einer Richtung zu der Trägerstreifenabschnittoberfläche (66) hin gebogen ist, auf der die zweite Schicht (72) ausgebildet ist, und
d) daß das integrale Element zur Bildung einer Ausnehmung abgetragen ist, die sich von den Enden (58) der Finger (56) in Richtung nach innen sowie entlang derjenigen Hauptfläche (60), welche der Hauptfläche mit der darauf ausgebildeten zweiten Schicht (72) gegenüberliegt, erstreckt und
e) die sich eine geringe Distanz um die Biegung herumerstreckt und in der eine Menge des Lötmaterials zur Bildung einer Vorform (82) angeordnet ist.

8. Lötkomponente (340) zur Verwendung beim Erleichtern des Verlötens einer Anordnung freier Enden (24) von Kontaktarmen (20) eines elektrischen Verbinders (10) mit einer entsprechenden Anordnung leitfähiger Einrichtungen (94) eines Schaltungselements (90), wobei die Lötkomponente in Verbindung mit einer Quelle von Hochfrequenz-Wechselstrom mit konstanter Amplitude und bekannter Frequenz sowie mit einem Leiterrahmen (360) ausgelegt ist, der einen länglichen Körperabschnitt (362) und sich quer von diesem wegerstreckend eine Vielzahl von Fingern (366) aufweist, deren jeder mit einem jeweiligen freien Ende (24) der Kontaktarme ausgerichtet ist und mit diesem in Verbindung steht und an denen jeweilige Mengen von Lötmaterial (388) wenigstens in der Nähe von den von den Leiterbahnen abgelegenen Flächen (38) der freien Enden (24) der Kontaktarme befestigt sind, wobei der Körperabschnitt (362) eine integrale Curiepunkt-Heizeinrichtung bildet, die zur Erzeugung von Wärmeenergie bis zum Erreichen einer bekannten maximalen ausgewählten Temperatur ausgelegt ist, wenn sie dem Strom bekannter Frequenz für eine ausgewählte Zeitdauer ausgesetzt wird, wobei die Lötkomponente (340) folgendes aufweist:
a) ein längliches Blockelement (342) aus wärmeisolierendem Material mit einer lötmaterialabweisenden Außenfläche, wobei die Außenfläche einen ersten Bereich (344) und einen zweiten Bereich (346) aufweist
aa) wobei der erste Bereich im wesentlichen planar ist und sich den Block entlangerstreckt, und
ab) wobei der zweite Bereich umfangsmäßig gekrümmt ausgebildet ist und an den ersten Bereich entlang einer Seitenkante desselben angrenzt,
b) wobei eine der Anordnung der Kontaktarme (20) entsprechende Anordnung von Nuten (350) in dem zweiten Bereich (346) definiert ist und sich in Querrichtung von dem Rand des ersten Bereichs (344) weg sowie über den zweiten Bereich (346) erstreckt;
c) wobei der Leiterrahmen (360) an der Außenfläche des Blockelements (342) befestigt ist, wobei der Körperabschnitt (362) an sowie den ersten Oberflächenbereich (344) entlang befestigt wird, und
d) wobei die Finger (366) länglich sind und derart ausgebildet sind, daß sie entlang von Bodenflächen (356) der jeweiligen Nuten (350) angeordnet werden;
e) wodurch eine Lötkomponente (340) gebildet ist, die sich an den freien Enden (24) der Kontaktarme befestigen läßt und ein Verlöten des Verbinders (10) mit dem Schaltungselement (90) ohne individuelle Neuausrichtung und Neubeabstandung der freien Enden der Kontaktarme in Ausfluchtung mit den leitfähigen Einrichtungen (94) des Schaltungselements vor dem Lötvorgang unter Erfordernis speziell dafür ausgebildeter Werkzeugeinrichtungen oder zum Plazieren von Lötmaterialmengen an den Verbindungsstellen oder zum Aussetzen des gesamten Schaltungselements und des Verbinders gegenüber hohen Temperaturen, die ansonsten zum Wiederverflüssigen des Lötmaterials erforderlich sind, ermöglicht.

9. Lötkomponente (340) nach Anspruch 8,
dadurch gekennzeichnet,
a) daß die Nuten (350) des Blockelements (342) schräge Seitenwände (354) aufweisen, so daß diese verbreiterte Eingänge entlang derselben aufweisen,
b) wodurch die Nuten (350) zum Aufnehmen jeweiliger freier Enden (24) der Kontaktarme beim Positionieren der Lötkomponente (340) angrenzend an die Kontaktarmanordnung ausgelegt sind.

## Revendications

1. Procédé de fixation d'un connecteur électrique (10) à un élément de circuit (90), le connecteur étant du type ayant au moins un groupement de bras de contact allongés (20) s'étendant depuis une face de montage (16) jusqu'à des extrémités libres (24) définissant des sections de contact (28) disposées dans un plan commun pour être soudées à un groupement correspondant de moyens conducteurs (94) définis sur une surface commune de l'élément de circuit (90) afin d'établir plusieurs connexions électriques et mécaniques entre le connecteur et l'élément de circuit, comprenant les étapes dans lesquelles :
a) on utilise une source pour générer un courant alternatif à haute fréquence, amplitude constante, de fréquence connue ;
b) on fixe auxdites extrémités libres (24) des bras de contact dudit connecteur (10), une grille de connexion (50, 360) ayant plusieurs doigts (56, 366) chacun en repérage avec une extrémité libre (24) de l'un, respectif, desdits bras de contact, à laquelle il est relié, et auxquels sont fixées des quantités respectives de soudure (80, 388), suffisamment proches desdites extrémités libres (24) des bras de contact pour être suffisamment proches de surfaces (28) de ceux-ci proches de pistes afin de s'écouler sur elles pendant un soudage,
c) ladite grille (50, 360) de connexion comprenant en outre une section de bande de support (52, 362) définissant un moyen chauffant intégré (70, 72 ; 380, 382) à point de Curie destiné à générer de l'énergie thermique jusqu'à atteindre une température maximale choisie et connue lorsqu'il est soumis audit courant de fréquence connue pendant un intervalle de temps choisi, et
d) ladite grille de connexion (50, 360) maintenant intégralement l'écartement desdites extrémités libres (24) des bras de contact après ladite jonction ;
e) on place ledit élément de circuit (90) à proximité immédiate desdites surfaces (28) proches des pistes desdites extrémités libres (24) des bras de contact, en alignement avec lesdits moyens conducteurs (94) ;
f) on génère ledit courant alternatif à haute fréquence, amplitude constante, dans ledit moyen chauffant (70, 72 ; 380, 382) pendant ledit intervalle de temps choisi ; et
g) on enlève au moins ladite section de bande de support (52, 362) desdits doigts (56, 366) de ladite grille de connexion, définissant ainsi . des circuits électriques discrets.

2. Procédé selon la revendication 1, caractérisé en ce que ladite étape d'enlèvement de ladite section de bande de support (52) de chaque grille (50) de connexion comprend au moins
a) le bridage de ladite grille de connexion contre une partie de surface principale adjacente dudit élément de circuit, à l'aide d'un outil (240) à arête vive en un emplacement situé le long desdits doigts (56) entre ladite section de bande de support (52) et ladite connexion soudée (83) desdites extrémités libres (24) des bras de contact sur lesdits moyens conducteurs respectifs, et
b) la manipulation de ladite section de bande de support (52) vers l'extérieur dudit emplacement pour y affaiblir et casser lesdits doigts (56).

3. Procédé selon la revendication 1 ou 2, caractérisé en ce que
a) ledit élément de circuit (90) comprend des groupements desdits moyens conducteurs (94) sur ses deux surfaces principales (98), afin qu'ils soient connectés électriquement à des groupements opposés (34) d'extrémités libres (24) de bras de contact dudit connecteur (10), et
b) ledit élément de circuit (90) est inséré entre lesdits groupements opposés (34) avant le soudage,
c) ledit procédé comprenant en outre, au moins avant le soudage de l'élément de circuit, l'étape de formation desdits groupements opposés (34) d'extrémités libres de bras de contact afin de les espacer d'une distance légèrement inférieure à l'épaisseur dudit élément de circuit auquel ledit connecteur doit être soudé.

4. Procédé selon la revendication 1 ou 2, comprenant en outre les étapes dans lesquelles, avant ladite étape de fixation :
a) on forme un élément à bloc allongé (342) de matière thermiquement isolante, ayant une surface extérieure résistant à la soudure, ladite surface extérieure ayant une première partie (344) et une seconde partie (346), ladite première partie étant sensiblement plane et s'étendant le long dudit élément à bloc, et ladite seconde partie étant à courbure douce et rejoignant ladite première partie suivant un bord latéral, un groupement de gorges (350) correspondant audit groupement de bras de contact étant défini dans ladite seconde partie, s'étendant transversalement depuis ladite première partie (344) et à travers ladite seconde partie (346) ; et
b) on fixe ladite grille de connexion (360) sur ladite surface extérieure dudit élément à bloc (342), ladite section de bande de support (362) étant fixée à, et le long de, ladite première partie de surface (344), et lesdits doigts (366) étant disposés le long de surfaces de fond (352) desdites gorges respectives (350), définissant des pièces à souder (340) ; et
c) ladite étape de fixation de ladite grille de connexion (360) auxdites extrémités libres (24) des bras de contact comprend le positionnement de ladite pièce à souder (340) à proximité immédiate de surfaces (38) éloignées des pistes des extrémités libres (24) d'un groupement respectif de bras de contact de façon que lesdites extrémités libres (24) des bras de contact soient reçues dans lesdites gorges respectives (350) et que lesdites parties extrêmes desdits doigts (366) soient alignées avec et contre certaines, respectives, desdites sections de contact (28), et de manière que ladite section de bande de support (362) soit tournée à l'écart dudit groupement de bras de contact.

5. Grille de connexion (50) utilisée pour faciliter le soudage d'un groupement (34) d'extrémités libres (24) de bras de contact (22) d'un connecteur électrique (10) sur un groupement correspondant de moyens conducteurs d'un élément à circuit (90), utilisable conjointement avec une source de courant alternatif à haute fréquence, amplitude constante, de fréquence connue, comportant :
a) un élément d'un seul bloc formé à partir d'une bande d'un premier métal ayant une faible résistance électrique et une perméabilité magnétique minimale, ledit élément d'un seul bloc définissant une première couche (70) ayant une section de bande (52) de support et plusieurs doigts (56) s'étendant sur une même distance depuis ladite section de bande de support et associés chacun avec certaines, respectives, auxquelles ils correspondent, desdites extrémités libres (24) desdits bras de contact (22) dudit groupement (34), et espacés desdites extrémités libres (24) ;
b) une seconde couche (72) d'un second métal, ayant une haute résistance électrique et une haute perméabilité magnétique, étant définie sur une surface principale de ladite section de bande de support (52) et étant jointe de façon intégrée à ladite première couche (70) de celle-ci, ladite seconde couche ayant une épaisseur au moins égale à une épaisseur de peau dudit second métal, étant donné ladite fréquence connue, ladite section de bande de support (52) définissant ainsi un moyen chauffant intégré à ladite grille de connexion (50) ; et
c) chacun desdits doigts (56) ayant de la soudure (80, 82) contenant un flux, disposée au moins sur des surfaces principales opposées (60, 62) de ce doigt, au moins à proximité d'extrémités libres (58) de celui-ci, définissant des préformes de soudure (80, 82), ladite soudure ayant une température nominale de refusion légèrement inférieure à la température de Curie dudit second métal,
d) grâce à quoi on définit une grille de connexion (50) pouvant être fixée auxdites extrémités libres (24) des bras de contact, permettant audit connecteur (10) d'être soudé audit élément de circuit (90) sans réaligner ni réespacer individuellement lesdites extrémités libres des bras de contact en repérage avec lesdits moyens conducteurs (94) de l'élément à circuit avant un soudage nécessitant un outillage devant être conçu spécialement à cet effet, ou pour placer des quantités de soudure auxdits sites des joints, ou pour soumettre l'ensemble de l'élément à circuit et du connecteur à des températures élevées nécessaires pour soumettre autrement la soudure à une refusion ;
caractérisée en ce que
e) ledit élément d'un seul bloc est entaillé de façon à définir un évidement (76 ou 78) s'étendant vers l'intérieur à partir d'extrémités (58) desdits doigts (56) le long d'au moins une surface (62 ou 60) de celui-ci, à l'intérieur duquel la soudure est disposée.

6. Grille de connexion (50) selon la revendication 5, caractérisée en ce qu'un groupement de trous (68) espacés et dimensionnés avec précision est découpé dans et le long de ladite section de bande de support, définissant des moyens pour déplacer ladite grille de connexion (50) afin de repérer lesdits doigts (56) avec des extrémités libres respectives (24) des bras de contact pendant le processus de fixage de la grille de connexion (50) audit groupement d'extrémités libres (24) de doigts de contact.

7. Grille de connexion (50) selon la revendication 5, caractérisée en ce que
a) ledit élément d'un seul bloc est formé de façon à définir un coude (84) le long des doigts, en un emplacement légèrement espacé de ladite section de bande de support (52), et
b) lesdites préformes de soudure (80, 82) s'étendent au moins jusqu'audit coude (84),
c) ledit élément d'un seul bloc est coudé en direction de ladite surface (66) de la section de bande de support sur laquelle ladite seconde couche (72) est définie, et
d) ledit élément d'un seul bloc est entaillé de façon à définir un évidement s'étendant vers l'intérieur à partir d'extrémités (58) desdits doigts (56) et le long d'une surface principale (60) opposée à celle sur laquelle est définie ladite seconde couche (72), et
e) s'étendant autour dudit coude sur une faible distance, à l'intérieur duquel une quantité de ladite soudure est disposée pour définir une préforme (82).

8. Pièce à souder (340) destinée à être utilisée pour faciliter le soudage d'un groupement d'extrémités libres (24) de bras de contact (20) d'un connecteur électrique (10) sur un groupement correspondant de moyens conducteurs (94) d'un élément à circuit (90), utilisable conjointement avec une source de courant alternatif à haute fréquence, amplitude constante, de fréquence connue, et une grille de connexion (360) ayant une section de corps allongée (362) et, s'étendant transversalement à partir de celle-ci, plusieurs doigts (366) chacun en repérage avec, et relié à, une extrémité libre (24) d'un bras de contact respectif, et auxquels sont fixées des quantités respectives de soudure (388), au moins à proximité de surfaces (38), éloignées des pistes, desdites extrémités libres (24) des bras de contact, la section de corps (362) définissant un moyen chauffant intégré à point de Curie destiné à générer de l'énergie thermique jusqu'à l'obtention d'une température maximale choisie et connue, lorsqu'il est soumis audit courant de fréquence connue pendant un intervalle de temps choisi, ladite pièce à souder (340) comportant ;
a) un élément à bloc allongé (342) en matière thermiquement isolante ayant une surface extérieure résistant à la soudure, ladite surface extérieure ayant une première partie (344) et une seconde partie (346),
aa) ladite première partie étant sensiblement plane et s'étendant le long dudit bloc, et
ab) ladite seconde partie étant circonférentiellement courbe et rejoignant ladite première partie suivant un bord latéral,
b) un groupement de gorges (350) correspondant audit groupement de bras de contact (20) étant défini dans ladite seconde partie (346), s'étendant transversalement depuis ledit bord de ladite première partie (344) et à travers ladite seconde partie (346) ;
c) ladite grille de connexion (360) étant fixée à ladite surface extérieure dudit élément à bloc (342), ladite section de corps (362) étant fixée à, et le long de, ladite première partie de surface (344), et
d) lesdits doigts (366) étant allongés et formés de façon à être disposés le long de surfaces de fond (352) desdites gorges respectives (350) ;
e) grâce à quoi une pièce à souder (340) est définie, laquelle peut être fixée auxdites extrémités libres (24) de bras de contact, permettant audit connecteur (10) d'être soudé audit élément à circuit (90) sans réaligner ni réespacer individuellement lesdites extrémités libres des bras de contact, en repérage avec lesdits moyens conducteurs (94) de l'élément à circuit, avant un soudage nécessitant un outillage qui doit être particulièrement adapté à cet effet, ou pour placer des quantités de soudure auxdits sites de joints ou pour soumettre l'ensemble de l'élément à circuit et du connecteur à des températures élevées nécessaires pour provoquer autrement une refusion de la soudure.

9. Pièce à souder (340) selon la revendication 8, caractérisée en ce que
a) lesdites gorges (350) dudit élément à bloc (342) ont des parois latérales inclinées (354) de façon à avoir des entrées élargies sur leur longueur,
b) grâce à quoi lesdites gorges (350) sont conçues pour recevoir en elles certaines, respectives, desdites extrémités libres (24) de bras de contact lors d'un positionnement de ladite pièce à souder (340) à proximité immédiate dudit groupement de bras de contact.
